**Europäisches Patentamt**

**European Patent Office**

**Office européen des brevets**

(19)

(11) Veröffentlichungsnummer: **0 204 135**
**B1**

(12) **EUROPÄISCHE PATENTSCHRIFT**

(45) Veröffentlichungstag der Patentschrift:
05.07.89

(51) Int. Cl.⁴: **H01L 43/06**

(21) Anmeldenummer: **86105812.1**

(22) Anmeldetag: **26.04.86**

(54) Einrichtung mit einem in einer integrierten Schaltung integrierbaren Hallelement.

(30) Priorität: **22.05.85 CH 2175/85**

(43) Veröffentlichungstag der Anmeldung:
**10.12.86 Patentblatt 86/50**

(45) Bekanntmachung des Hinweises auf die Patenterteilung:
**05.07.89 Patentblatt 89/27**

(84) Benannte Vertragsstaaten:
**AT BE CH DE FR GB IT LI NL SE**

(56) Entgegenhaltungen:
**EP-A- 0 162 165**

**IEEE ELECTRON DEVICE LETTERS, Band EDL-5, Nr. 9,
September 1984, Seiten 357-358, IEEE, New York, US;
R.S. POPOVIC: "The vertical hall-effect device"
IBM TECHNICAL DISCLOSURE BULLETIN, Band 22,
Nr. 9, Februar 1980, Seiten 4006-4008, New York, US;
S.S. HEGEDUS: "Piezoresistive stress independent hall
device"
IBM TECHNICAL DISCLOSURE BULLETIN, Band 21,
Nr. 7, Dezember 1978, Seiten 2717-2718, New York, US;
J.P. BOLASH et al.: "Monolithic hall cell system"**

(73) Patentinhaber: **LGZ LANDIS & GYR ZUG AG,
CH-6301 Zug(CH)**

(72) Erfinder: **Popovic, Radivoje, Fridbach 1,
CH-6300 Zug(CH)**

(74) Vertreter: **Müller, Hans–Jürgen, Dipl.-Ing. et al, Müller,
Schupfner & Gauger
Lucile-Grahn-Strasse 38 Postfach 80 13 69,
D-8000 München 80(DE)**

**Beschreibung**

Die Erfindung bezieht sich auf eine Einrichtung mit einem in einer integrierten Schaltung integrierbaren Hallelement gemäß dem Oberbegriff des Anspruchs 1.

Derartige Einrichtungen werden z.B. in Leistungsmessern oder Elektrizitätszählern verwendet zum Messen eines elektrischen Stromes $i_N$ oder zur Bildung eines Spannungs/Strom-Produktes $u_N \cdot i_N$. Dabei bezeichnet $u_N$ die Netzspannung eines elektrischen Versorgungsnetzes und $i_N$ den von einem Benützer elektrischer Energie verbrauchten elektrischen Strom. Da der Strom $i_N$ proportional einem von ihm erzeugten Magnetfeld $H_N$ ist, misst das Hallelement indirekt den Strom $i_N$, wenn es das Magnetfeld $H_N$ ermittelt. Da die Ausgangsspannung $V_H$ des Hallelementes proportional dem Produkt $i \cdot H_N$ ist, wobei $i$ den Speisestrom des Hallelementes darstellt, bildet das Hallelement auch das Spannungs/Strom-Produkt $u_N \cdot i_N$, wenn der Speisestrom $i$ des Hallelementes mit Hilfe z.B. eines Widerstandes proportional der Netzspannung $u_N$ gewählt wird. In diesem Fall muss das Hallelement als Vierquadrant-Multiplikator arbeiten, da $u_N$ und $i_N$ bzw. $i$ und $H_N$ sinusförmig sind und somit positive und negative Werte besitzen.

Ein integrierbares vertikales Hallelement gemäß dem Oberbegriff des Anspruchs 1 ist aus der Druckschrift "The vertical hall-effect device", R.S. Popovic, IEEE Electron Device Letters, Vol. EDL-5, No. 9, Sept. 84, Seiten 357–358, bekannt. Vertikale integrierbare Hallelemente sind Hallelemente, die Magnetfelder $H_N$ messen, die parallel zur Oberfläche des integrierten Hallelementes wirksam sind.

Ein integrierbares horizontales Hallelement gemäß dem Oberbegriff des Anspruchs 1 ist aus der US-PS 4 253 107 bekannt. Horizontale integrierbare Hallelemente sind Hallelemente, die Magnetfelder $H_N$ messen, die senkrecht zur Oberfläche des integrierten Hallelementes wirksam sind.

Ein integrierbares horizontales Hallelement ist in der für Deutschland, Frankreich, Grossbritannien, Italien und die Niederlande vorangemeldeten, jedoch nachveröffentlichten EP 0 162 165 A2 beschrieben (Art. 54 [3] und [4], EPÜ). Dieses integrierbare horizontale Hallelement besitzt zwei Sensor-Anschlußkontakte und zwei Strom-Anschlußkontakte, die an der Oberfläche im horizontalen Hallelement angeordnet sind, wobei mindestens zwischen der aktiven Zone und der Oberfläche des Hallelementes eine Sperrschicht angeordnet ist, die die aktive Zone des Hallelementes nach oben hin abdeckt. Dabei ist die Sperrschicht gebildet durch die Grenzschicht zwischen der aktiven Zone des Hallelementes und einer an der Oberfläche im Hallelement angeordneten Schicht, die vom entgegengesetzten Materialleitfähigkeitstyp ist wie die aktive Zone des Hallelementes und die diese aktive Zone nach oben hin abdeckt.

Betreffend der Stabilität und insbesondere der Langzeitstabilität von Hallelementen ist, wie z.B. ersichtlich aus der Druckschrift "Hall effect probes and their use in a fully automated magnetic measuring system", M.W. Poole und R.P. Walker, IEEE Transactions on Magnetics, Vol. MAG-17, No. 5, Sept. 81, Seite 2132, nur wenig und nur Prinzipielles bekannt.

Der Erfindung liegt die Aufgabe zugrunde, integrierbare Hallelemente langzeitstabil zu machen unter Verwendung einer Technologie, die es gestattet, gleichzeitig integrierbare Hallelemente und integrierbare Transistoren herzustellen.

Die genannte Aufgabe wird erfindungsgemäss durch die im Kennzeichen des Anspruchs 1 (Fassung für AT, BE, CH, LI und SE) angegebenen Merkmale gelöst.

Weitere Aufgaben, die durch Merkmale von Unteransprüchen gelöst werden, sind integrierbare Hallelemente temperaturstabil zu machen und ihre Kennlinie $V_H = f(B)$ bei konstantem, gegebenem Speisestrom $i$ zu linearisieren. Dabei bezeichnet $V_H$ die Ausgangsspannung des Hallelementes und $B = \mu H_N$ die Induktion des zu messenden Magnetfeldes $H_N$.

Ausführungsbeispiele der Erfindung sind in der Zeichnung dargestellt und werden im folgenden näher beschrieben.

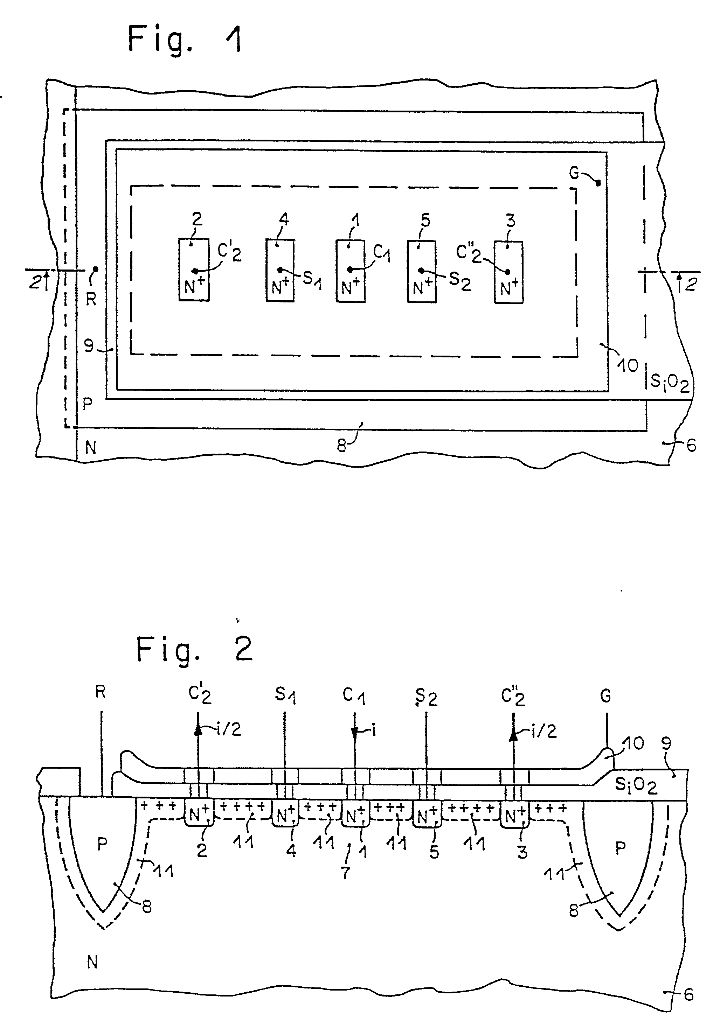

Es zeigen: Fig. 1 eine Draufsicht eines integrierbaren stabilen vertikalen Hallelementes in CMOS-Technologie,

Fig. 2 einen zur Fig. 1 gehörenden vertikalen Querschnitt des dort dargestellten Hallelementes,

Fig. 3 eine Draufsicht eines integrierbaren stabilen vertikalen Hallelementes in abgeänderter CMOS-Technologie,

Fig. 4 einen Fig. 3 und zur Fig. 5 gehörenden vertikalen Querschnitt des dort jeweils dargestellten Hallelementes,

Fig. 5 einen horizontalen Querschnitt eines integrierbaren stabilen vertikalen Hallelementes mit "Sandwich"-Aufbau in abgeänderter CMOS-Technologie,

Fig. 6 eine Draufsicht einer ersten Variante eines integrierbaren stabilen vertikalen Hallelementes in abgeänderter Bi MOS-Technologie,

Fig. 7 einen zur Fig. 6 gehörenden vertikalen Querschnitt des dort dargestellten Hallelementes,

Fig. 8 eine Draufsicht einer zweiten Variante eines integrierbaren stabilen vertikalen Hallelementes in abgeänderter Bi MOS-TECHNOLOGIE,

Fig. 9 einen zur Fig. 8 gehörenden vertikalen Querschnitt des dort dargestellten Hallelementes,

Fig. 10 eine Draufsicht eines bipolaren Transistors in abgeänderter Bi MOS-Technologie,

Fig. 11 einen zur Fig. 10 gehörenden vertikalen Querschnitt des dort dargestellten bipolaren Transistors,

Fig. 12 eine Draufsicht eines integrierbaren stabilen horizontalen Hallelementes in Bi MOS-Technologie,

Fig. 13 einen zur Fig. 12 gehörenden vertikalen Querschnitt des dort dargestellten Hallelementes,

Fig. 14 eine Draufsicht eines intgrierbaren stabilen horizontalen Hallelementes in abgeänderter Bi MOS-Technologie,

Fig. 15 einen zur Fig. 14 gehörenden vertikalen Querschnitt des dort dargestellten Hallelementes,

Fig. 16 eien Anschluss-Schaltbild eines integrierbaren vertikalen Hallelementes mit fünf Anschlüssen,

Fig. 17 ein Blockschaltbild einer Einrichtung mit einem Hallelement

Fig. 18 eine Kennlinie $V_H = f(B)$ der Ausgangsspannung $V_H$ eines Hallelementes in Funktion einer gemmessenen Induktion B bei gegebenem Speisestrom i,

Fig. 19 Kennlinien geradpaariger Nichtlinearitäten $\varepsilon$ (B),

Fig. 20 Kennlinien ungeradpaariger Nichtlinearitäten $\varepsilon(B)$,

Fig. 21 eine Draufsicht einer verbesserten Variante des in den Figuren 1 und 2 dargestellten Hallelementes,

Fig. 22 einen zur Fig. 21 gehörenden vertikalen Querschnitt des dort dargestellten Hallelementes,

Fig. 23 eine Draufsicht einer verbesserten Variante des in den Figuren 3 und 4 dargestellten Hallelementes,

Fig. 24 einen zur Fig. 23 gehörenden vertikalen Querschnitt des dort dargestellten Hallelementes und

Fig. 25 ein Ersatzschaltbild mit Beschaltung des in den Figuren 21 bis 24 dargestellten Hallelementes.

Gleiche Bezugszahlen bezeichnen in allen Figuren der Zeichnung gleiche Teile. Die in der Zeichnung dargestellten Hallelemente sind alle. Oberflächen-Bauelemente, d.h. sie befinden sich alle an der Oberfläche oder unmittelbar unterhalb der Oberfläche eines Halbleitermaterials.

Die in den Figuren 1 bis 15 dargestellten Hallelemente bzw. Transistoren sind aus Silizium- oder aus Gallium/Arsenid (GaAs)-Material hergestellt. Sie bestehen in der Regel aus Schichten eines dieser beiden Materialien. Alle diese Schichten sind entweder vom Materialleitfähigkeitstyp P oder vom entgegengesetzten Materialleitfähigkeitstyp N. Die Bezeichnung N+ und P+ deuten an, dass das entsprechende N- bzw. P-Material stark mit Fremdatomen dotiert ist,d.h. mindestens eine Konzentration von annähernd $10^{20}$ Ionen pro $cm^3$ besitzt. Umgekehrt deuten die Bezeichnungen N− und P− an, dass das entsprechende N- bzw. P-Material schwach mit Fremdatomen dotiert ist.

Die in den Figuren 1 bis 15 dargestellten Hallelemente bzw. Transistoren können sowohl aus P- als auch aus N-Material ausgehend hergestellt werden, was keinen Einfluss auf ihre Funktion hat unter der Bedingung, dass die Polaritäten der zugehörigen Speisespannungen bzw. Speiseströme entsprechend richtig gewählt werden. In der Zeichnung wurde einfachshalber angenommen, dass die Hallelemente immer von N-Material ausgehend hergestellt sind, was keine Einschränkung des Erfindungsgegenstandes darstellen soll.

In den Figuren 1 bis 15 wurden einfachshalber in der Regel die elektrischen Anschlüsse $C_1$, $C_2$, $C'_2$, $C''_2$, $S_1$, $S_2$, R und SUB des Hallelementes bzw. B, E, und C der Transistoren als Drähte dargestellt. In der Praxis haben sie natürlich die Gestalt von Metallisierungen, die als dünne Leitbahnen auf die Oberfläche des integrierten Hallelementes bzw. der dazugehörigen integrierten Schaltung aufgetragen sind.

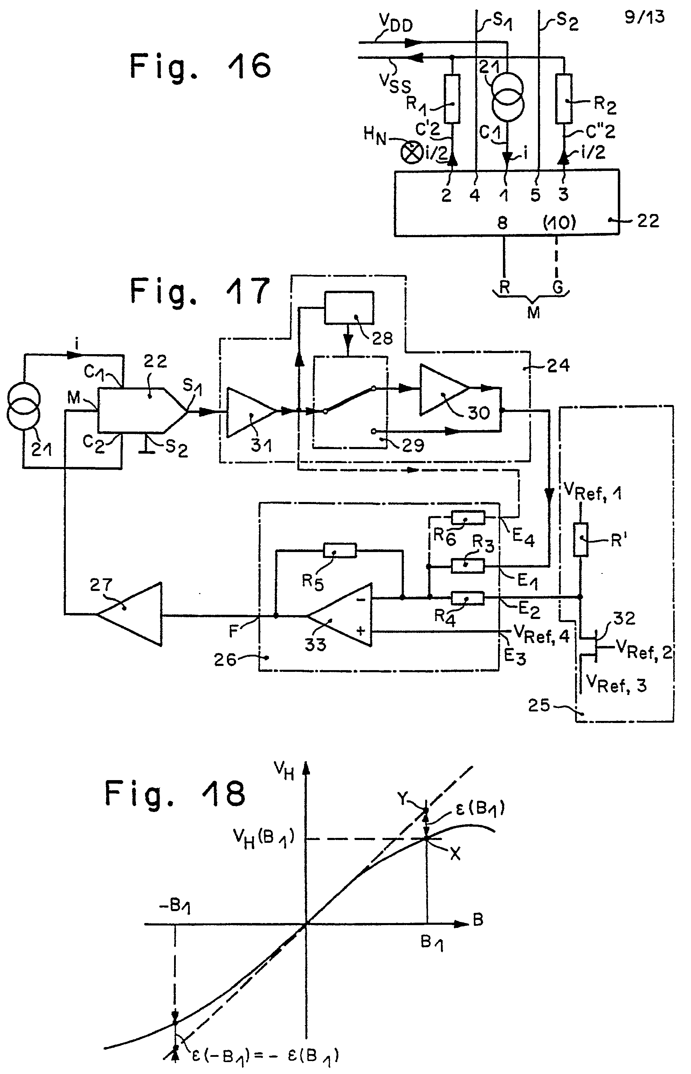

Alle in den Figuren 12 bis 15 dargestellten Hallelemente besitzen zwei Stromanschlüsse $C_1$ und $C_2$ sowie zwei Sensoranschlüsse $S_1$ und $S_2$. Alle in den Figuren 1 bis 9 dargestellten Hallelemente besitzen drei Stromanschlüsse $C_1$, $C'_2$ und $C''_2$ sowie zwei Sensoranschlüsse $S_1$ und $S_2$. In diesem Fall ist das Hallelement mit den fünf Strom- bzw. Sensor-Anschlüssen $C_1$, $C'_2$, $C''_2$, $S_1$ und $S_2$ immer wie in der Fig. 16 dargestellt extern zu beschalten. In der Fig. 17 wurde einfachshalber das Vorhandensein eines Hallelementes mit vier Strom- bzw. Sensor-Anschlüssen $C_1$, $C_2$, $S_1$ und $S_2$ angenommen, was keine Einschränkung auf eine "Vier Anschluss-Variante" darstellen soll.

In allen Varianten liegt z.B. einer der beiden Sensoranschlüsse $S_1$ bzw. $S_2$ an Masse und der andere Sensoranschluss $S_2$ bzw. $S_1$ bildet den Ausgang des Hallelementes. In der Zeichnung wurde angenommen, dass der erste Sensoranschluss $S_1$ den Ausgang des Hallelementes bildet und das der zweite Sensoranschluss $S_2$ an Masse liegt.

Die elektrischen Anschlüsse $C_1$, $C_2$ bzw. $C'_2$, $C''_2$, $S_1$ und $S_2$ des Hallelementes besitzen je einen Anschlusskontakt 1, 2, 3, 4 bzw. 5.

In den Figuren 1 bis 9 sind fünf Anschlusskontakte 1, 2, 3, 4 und 5 an der Oberfläche im vertikalen Hallelement angeordnet. Die Anschlusskontakte 1 bis 5 sind alle annähernd in einer geraden Linie nebeneinander angeordnet, wobei der erste Strom-Anschlusskontakt 1 in der Mitte liegt und die beiden Sensor-Anschlusskontakte 4 und 5 einerseits und die beiden anderen Strom-Anschlusskontakte 2 und 3 anderseits symmetrisch zum ersten Strom-Anschlusskontakt 1 auf der annähernd geraden Linie angeordnet sind. Jeder Sensor-Anschlusskontakt 4 bzw. 5 liegt dabei jeweils zwischen dem ersten Strom-Anschlusskontakt 1 und einem der beiden andern Strom-Anschlusskontakte 2 bzw. 3.

In den Figuren 12 bis 15 sind horizontale Hallelemente dargestellt, die statt der drei Stromanschlüsse $C_1$, $C'_2$ und $C''_2$ der vertikalen Hallelemente nur mehr zwei Stromanschlüsse $C_1$ und $C_2$ besitzen, wobei die beiden Sensoranschlüsse $S_1$ und $S_2$ einerseits und die beiden Stromanschlüsse $C_1$ und $C_2$ ander-

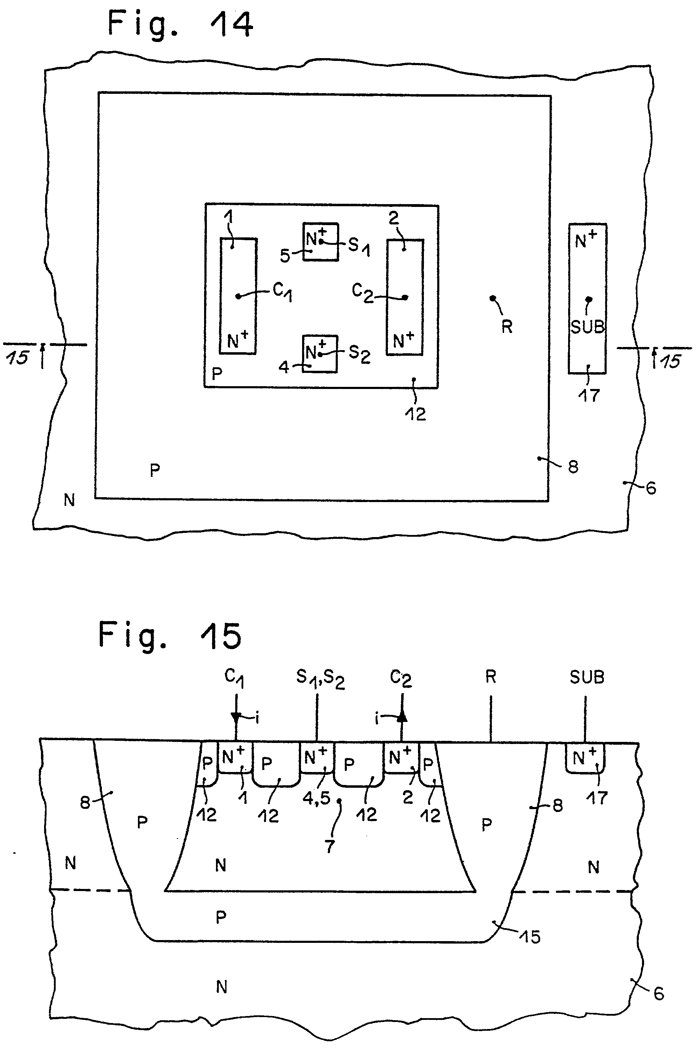

seits über Kreuz zueinander angeordnet sind, d.h. die Verbindungslinie zwischen den Mittelpunkten der beiden zu den Sensoranschlüssen $S_1$ und $S_2$ gehörenden Anschlusskontakte 4 und 5 und die Verbindungslinie zwischen den Mittelpunkten der beiden zu den Stromanschlüssen $C_1$ und $C_2$ gehörenden Anschlusskontakte 1 und 2 verlaufen annähernd senkrecht zueinander (siehe Fig. 12 und Fig. 14).

In allen Fällen sind die Anschlusskontakte 1 bis 5 bzw. 1, 2, 4 und 5 z.B. alle gleich gross und haben z.B. alle eine gleiche rechteckförmige Gestalt mit abgerundeten Kanten. Unterhalb der an der Oberfläche im Hallelement angeordneten fünf bzw. vier Anschlusskontakte 1 bis 5 bzw. 1, 2, 4 und 5 befindet sich jeweils, z.B. in einem Substrat 6, die aktive Zone 7 des Hallelementes. Mit andern Worten: Das integrierbare Hallelement besitzt zwei Sensor-Anschlusskontakte 4 und 5 sowie mindestens zwei Strom-Anschlusskontakte 1 und 2, die an der Oberfläche im Hallelement angeordnet sind. Alle Anschlusskontakte 1 bis 5 und die aktive Zone 7 des Hallelementes bestehen aus Material vom gleichen Materialleitfähigkeitstyp wie das Ausgangsmaterial, aus dem das Hallelement hergestellt ist. Alle Anschlusskontakte 1 bis 5 sind ausserdem stark mit Fremdatomen dotiert. Da das Hallelement als von N-Material ausgehend hergestellt angenommen wurde, bestehen alle Strom- und Sensor-Anschlusskontakte 1 bis 5 aus N+-Material und die aktive Zone 7 des Hallelementes aus N- bzw. N⁻-Material.

Die aktive Zone 7 des Hallelementes ist z.B. seitlich von einem Ring 8 umgeben, wobei der Ring 8 jeweils einen Ringanschluss R besitzt. In allen Fällen ist der Ring 8 vom entgegengesetzten Materialleitfähigkeitstyp wie die aktive Zone 7 und die Sensor- und Strom-Anschlusskontakte 1 bis 5 des Hallelementes. Er besteht in unserem Beispiel also aus P-Material.

Die Figuren 1 und 2 zeigen die Draufsicht und einen vertikalen Querschnitt eines in CMOS-Technologie hergestellt vertikalen Hallelementes. Die Anschlusskontakte 1 bis 5 sind an der Oberfläche in dem Substrat 6 angeordnet. Die Anschlusskontakte 1 bis 5 und das Substrat 6 bestehen aus gleichem z.B. N-Material. Unterhalb der fünf Anschlusskontakte 1 bis 5 befindet sich im Substrat 6 die aktive Zone 7 des Hallelementes. Die aktive Zone 7 ist innerhalb des Substrates 6 seitlich von dem z.B. rechteckförmigen Ring 8 umgeben, der an der Oberfläche im Substrat 6 angeordnet ist und bedeutend tiefer ist als die Tiefe der Anschlusskontakte 1 bis 5. Der Ring 8 ist, wie bereits erwähnt, vom entgegengesetzten Materialleitfähigkeitstyp wie das Substrat 6 und besteht aus P-Material. Auf der Oberfläche des Substrates 6 befindet sich eine Oxydschicht 9 aus $SiO_2$-Material, die ihrerseits zumindestens teilweise mit einer Gateschicht 10 aus elektrisch leitendem Material, z.B. aus Aluminium oder Polysilicon, bedeckt ist. Der Ring 8 besitzt den Ringanschluss R und die Gateschicht 10 einen Gateanschluss G.

Abgesehen von den Durchführungen für die Anschlüsse $C_1$, $C'_2$, $C''_2$, $S_1$ und $S_2$ bedeckt die Gateschicht 10 vollständig die aktive Zone 7 des Hallelementes nach oben hin. Liegt jetzt am Gateanschluss G eine negative elektrische Spannung, so entsteht durch elektrostatische Influenz an der Oberfläche im Substrat 6 rund um die Anschlusskontakte 1 bis 5 ein in der Zeichnung durch Plus-Zeichen angedeuteter P-Kanal und unterhalb desselben sowie entlang der Uebergangsfläche zwischen Substrat 6 und Ring 8 eine Verarmungszone ("depletion layer"). Die Verarmungszone, die in der Fig. 2 gestrichelt dargestellt ist, stellt eine Sperrschicht 11 dar. Mit andern Worten: Eine Sperrschicht 11 wird gebildet durch die Verarmungszone, die durch elektrostatische Influenz mit Hilfe einer elektrischen Spannung erzeugt wird, die über den Gateanschluss G an der elektrisch leitenden Gateschicht 10 anliegt. Die Gateschicht 10 ist dabei, getrennt durch die Oxydschicht 9, auf die Oberfläche des Hallelementes so angeordnet, das sie und damit auch die Verarmungszone die aktive Zone 7 des Hallelementes nach oben hin möglichst vollständig abdeckt.

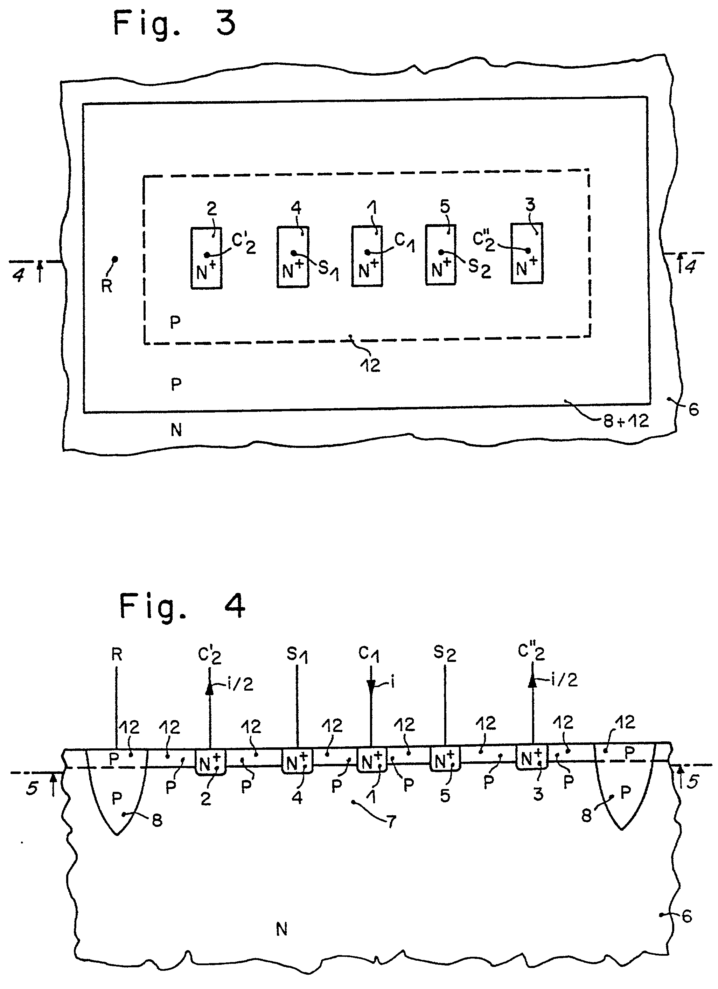

Die Figuren 3 und 4 zeigen die Draufsicht und einen vertikalen Querschnitt eines in abgeänderter CMOS-Technologie hergestellten vertikalen Hallelementes, das ähnlich aufgebaut ist wie das in den Figuren 1 und 2 dargestellte vertikale Hallelement, nur dass hier die Gateschicht 10 mit ihrem Gateanschluss G und die Oxydschicht 9 fehlen. Dafür ist rund um die Anschlusskontakte 1 bis 5 an der Oberfläche im Substrat 6 eine Schicht 12 angeordnet, die, abgesehen von den Durchführungen für die Anschlusskontakte 1 bis 5, die aktive Zone 7 des Hallelementes vollständig nach oben hin bedeckt. Die Schicht 12 ist vom entgegengesetzten Materialleitfähigkeitstyp wie die aktive Zone 7 des Hallelementes und besteht demnach aus P-Material. Die Grenzschicht zwischen aktiver Zone 7 des Hallelementes und der Schicht 12 bildet einer Sperrschicht 12; 7, die ebenfalls die aktive Zone 7 des Hallelementes fast vollständig nach oben hin abdeckt. Aus Gründen der einfacheren Herstellung bedeckt die Schicht 12 auch den oberen Teil des Ringes 8, was kein Nachteil ist, da die Schicht 12 und der Ring 8 vom gleichen Materialleitfähigkeitstyp P sind. Dadurch entsteht ein elektrischer Kontakt von der Schicht 12 zum Ring 8 und zu dessen Ringanschluss R. Ist der Ring 8 nicht vorhanden, so ist die Schicht 12 selber mit einem Ringanschluss R versehen.

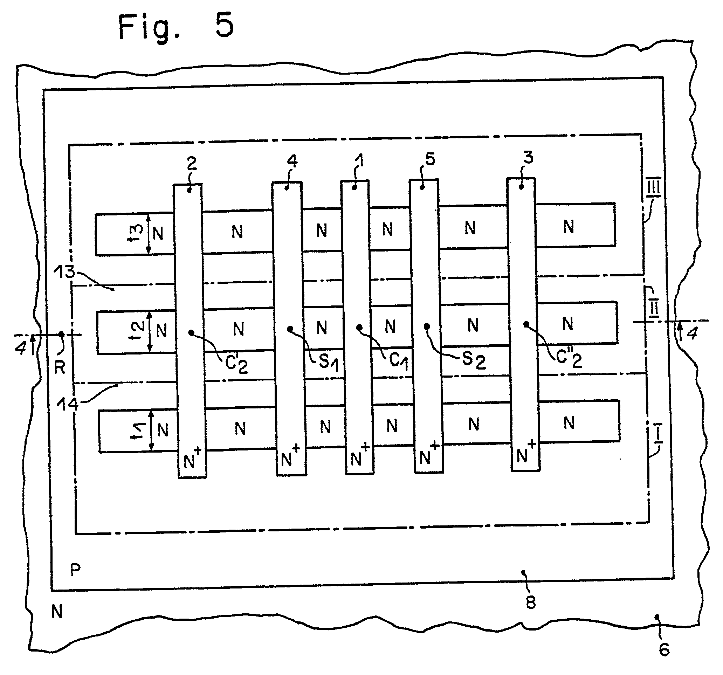

Das in der Fig. 5 dargestellte vertikale Hallelement in abgeänderter CMOS-Technologie ist eine verbesserte Variante des in den Figuren 3 und 4 dargestellten vertikalen Hallelementes. Als zweite Ansicht gehört zur Fig. 5 die Fig. 4. Die Figur 5 stellt einen parallel zur Oberfläche des Hallelementes verlaufenden Querschnitt des Hallelementes dar, der unmittelbar unterhalb der Schicht 12 verläuft (siehe Fig. 4).

Die Figuren 5 und 4 zeigen einen horizontalen und einen vertikalen Querschnitt eines mit "Sandwich"-Aufbau hergestellten vertikalen Hallelementes. Das in der Fig. 5 dargestellte Hallelement unterscheidet sich von demjenigen, das in der Fig. 3 dargestellt ist, dadurch, dass alle Strom- und Sensor-Anschlusskontakte 1 bis 5 des Hallelementes in einer gleichen Richtung länglich sind und dass der Ring 8 durch Zwischenstege 13 und 14, die annähernd senkrecht zur Längsrichtung der Strom- und Sensor-Anschlusskontakte 1 bis 5 verlaufen, in nebeneinanderliegende Unterringe I, II und III unterteilt ist, die alle, senkrecht zur Längsrichtung der Strom- und Sensor-Anschlusskontakte 1 bis 5, eine annähernd gleiche Breite besitzen und die alle in dieser Längsrichtung, ohne gegenseitige Verschiebung, übereinander angeordnet sind, wobei zwei benachbarte Unterringe jeweils einen gemeinsamen Zwischensteg 13 bzw. 14 besitzen. m Zwischenstege bilden somit (m+1) Unterringe. Mit m=1 entsteht demnach eine aus zwei Unterringen bestehenden rechteckförmige Acht. Die Anzahl (m+1) Unterringe kann beliebig gross gewählt werden. In der Fig. 5 wurde das Vorhandensein sein von drei Unterringen I, II und III angenom-men. Es wird so ein "Sandwich" Aufbau des Hallelementes erzielt, da, in der Darstellung der Fig. 5 von oben nach unten, P- und N-Schichten sich in der Nähe der Stromund Sensor-Anschlusskontake 1 bis 5 gegenseitig abwechseln. Alle Strom- und Sensor-Anschlusskontakte 1 bis 5 müssen genügend lang sein, um alle N-Schichten zu überbrücken, die von Unterringen umgeben sind. Die Dicken dieser N-Schichten sind in der Fig. 5 mit $t_1$, $t_2$ und $t_3$ bezeichnet, wobei $t_1 \approx t_2 \approx t_3$. Alle diese N-Schichten sind elektrisch parallel geschaltet. Dieser "Sandwich"-Aufbau hat den Vorteil, dass die Empfindlichkeit der Dicke der aktiven Zone 7 in Abhängingkeit einer am Ringanschluss R anliegenden elektrischen Spannung um einen Faktor m grösser ist als bei Verwendung eines Hallelementes mit einem Ring 8 ohne Zwischenstege.

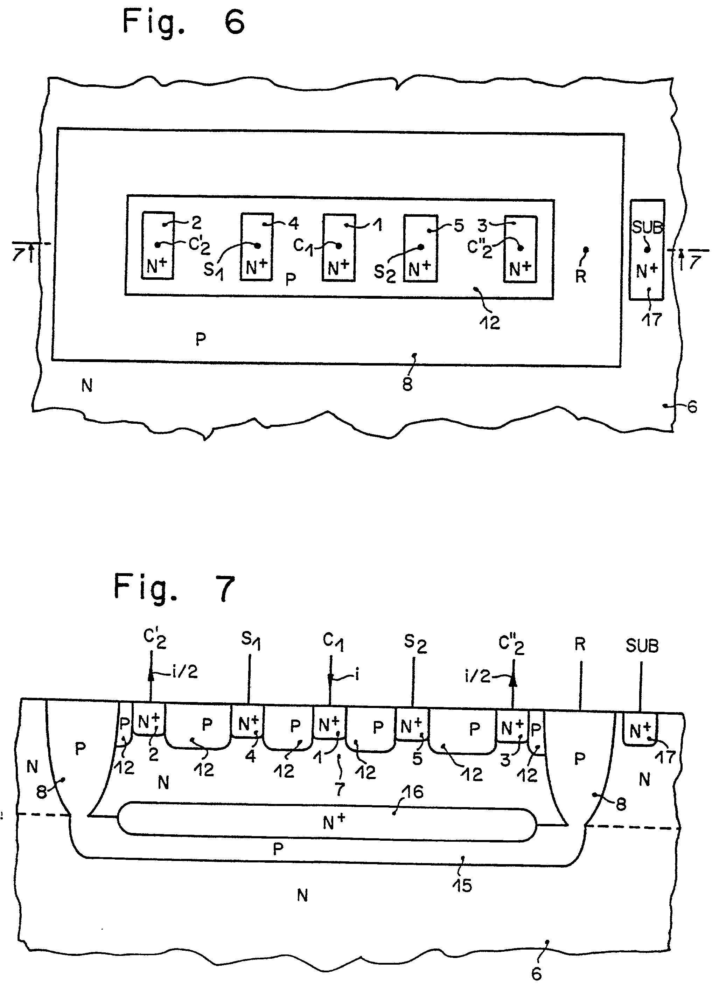

Die Figuren 6 und 7 zeigen die Drausicht und einen vertikalen Querschnitt einer ersten Variante eines in abgeänderter Bi MOS-Technologie hergestellten vertikalen Hallelementes. Dieses Hallelement ist ähnlich aufgebaut wie das in den Figuren 3 und 4 dargestellte Hallelement, mit dem wichtigen Unterschied, dass der Ring 8 jetzt noch eine Bodenplatte 15 besitzt, die aus dem gleichen Material P besteht wie der eigentliche Ring 8. Die Kombination aus Ring 8 und Bodenplatte 15 umgibt jetzt die aktive Zone 7 nicht nur seitlich, sondern auch nach unten hin. An der Grenzfläche zwischen Bodenplatte 15 und aktive Zone 7 des Hallelementes befindet sich ausserdem noch eine vergrabene Schicht 16 ("burried layer") aus stark mit Fremdatomen dotiertem Material vom gleichen Materialleitfähigkeitstyp N wie das Substrat 6. Das Substrat 6 besitzt einen Anschlusskontakt 17 aus stark mit Fremdatomen dotiertem Material, der an der Oberfläche des Hallelementes im Substrat 6 eingebaut ist und der mit einem äusseren Anschluss SUB verbunden ist. Der Anschlusskontakt 17 ist vom gleichen Materialleitfähigkeitstyp N wie das Substrat 6.

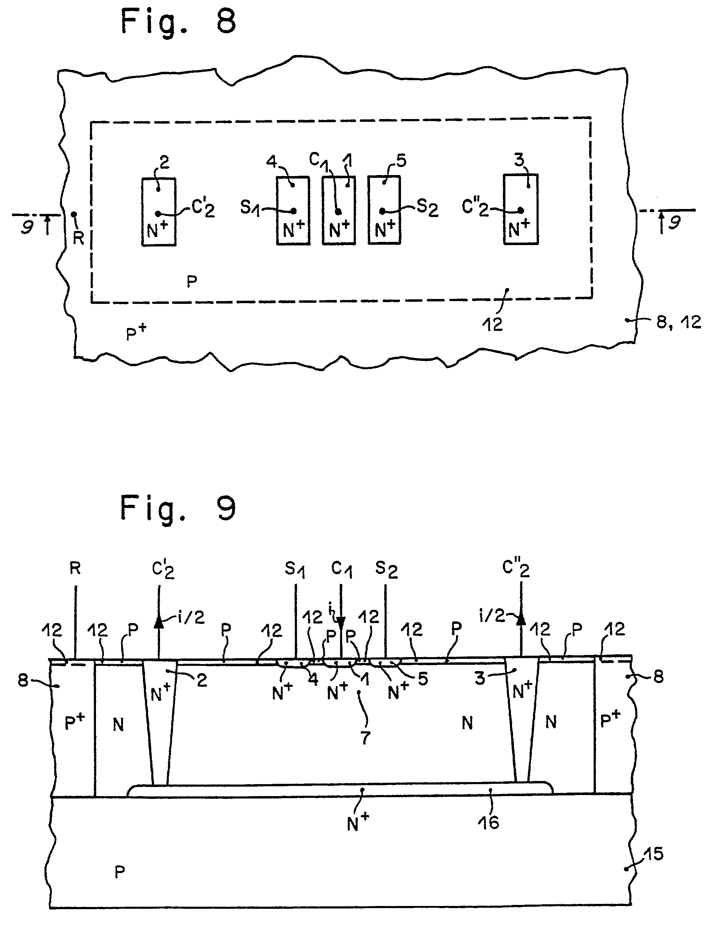

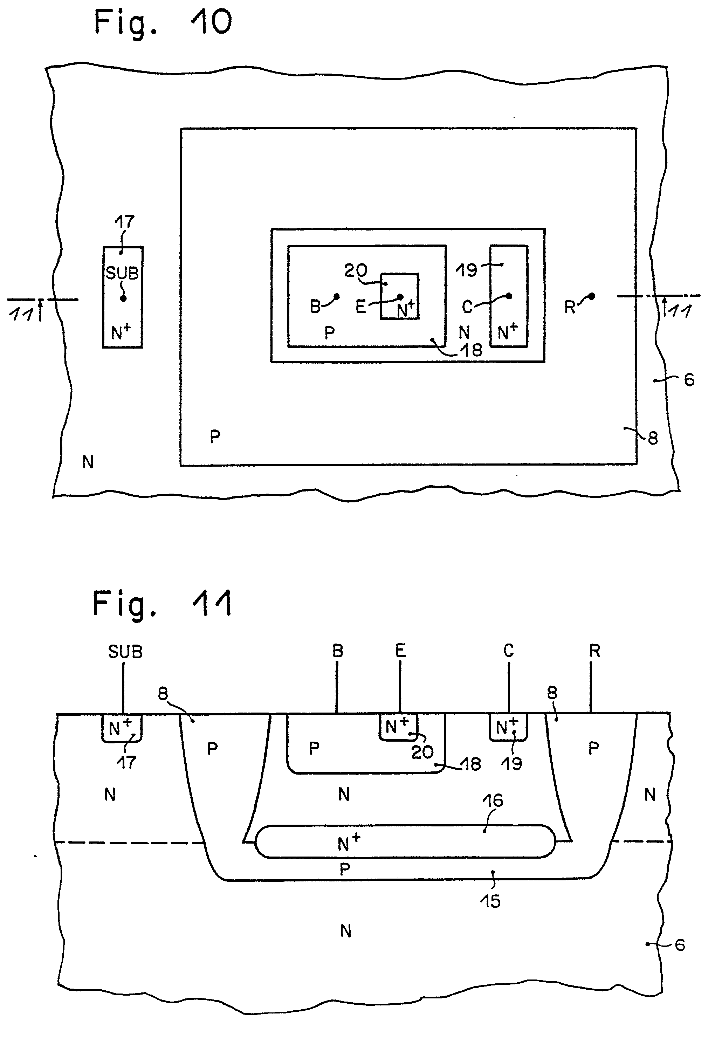

Die Figuren 8 und 9 zeigen die Draufsicht und einen vertikalen Querschnitt einer zweiten Variante eines in abgeänderter Bi MOS-Technologie hergestellten vertikalen Hallelementes. Dieses Hallelement ist ähnlich aufgebaut wie das in den Figuren 6 und 7 dargestellte Hallelement, mit dem Unterschied, dass die zum Ring 8 gehörende Bodenplatte 15 gleichzeitig als mechanischer Träger für das Hallelement dient und so das Substrat 6 ersetzt, und dass die beiden äusseren Stromanschlusskontakte 2 und 3 in der Tiefe verlängert sind bis zu ihrem Kontakt mit der vergrabenen Schicht 16. Auch fehlt das Substrat 6 mit dem zu ihm gehörenden Anschlusskontakt 17. Aus Gründen der zeichnerischen Einfachheit ist der Ring 8, im Gegensatz zu dem in der Figur 7 dargestellten Ring 8, in der Fig. 9 mit rechteckförmigem Querschnitt dargestellt, was keinen Einfluss auf die Funktion hat. Der Ring 8 ist ausserdem stark mit Fremdatomen dotiert.

Die Figuren 10 und 11 zeigen die Draufsicht und einen vertikalen Querschnitt eines in abgeänderter Bi MOS-Technologie hergestellten Bipolar-Transistors. Sein Aufbau ist, was Substrat 6, Ring 8, Bodenplatte 15, vergrabene Schicht 16 und Anschlusskontakt 17 anbelangt, genau gleich wie beim in den Figuren 6 und 7 dargestellten Hallelement. Der Bipolar-Transistor besitzt allerdings nur drei statt fünf Anschlüsse, nämlich einen Kollektor-Anschluss C, einen Emitter-Anschluss E und einen Basis-Anschluss B. Der Basis-Anschluss B ist mit einer BasisWanne 18 verbunden, die vom entgegengesetzten Materialleitfähigkeitstyp wie das Substrat 6 ist, also aus P-Material besteht. Der Kollektor-Anschluss C und der Emitter-Anschluss E besitzen je einen Anschlusskontakt 19 bzw. 20 aus stark mit Fremdatomen dotiertem Material. Der Anschlusskontakt 19 ist an der Oberfläche im Substrat 6 und der Anschlusskontakt 20 an der Oberfläche in der Basis-Wanne 18 angeordnet. Beide Anschlusskontakte 19 und 20 sind vom gleichen Materialleitfähigkeitstyp wie das Substrat 6, d.h. sie bestehen aus N-Material. Der Ring 8 umgibt seitlich den Anschlusskontakt 19 und die Basis-Wanne 18 genau so, wie er in der Figur 7 die Anschlusskontakte 1 bis 5 umgibt. Eine Schicht 12 aus P-Material ist hier nicht vorhanden. Wie ein Vergleich der Figuren 6 und 7 einerseits und der Figuren 10 und 11 andererseits zeigt, sind die dort dargestellten Bauelemente ähnlich aufgebaut, so·dass es ohne weiteres möglich ist, beide Bauelementearten in einer einzigen integrierten Schaltung mit gleicher Technologie einzubauen zwecks Realisierung der in der Fig. 17 dargestellten Schaltung.

Die in den Figuren 1 bis 9 dargestellten Hallelemente mit fünf Strom- bzw. Sensor-Anschlüsse $C_1$, $C'_2$, $C''_2$, $S_1$ und $S_2$ sind, wie bereits erwähnt, extern wie in der Fig. 16 dargestellt zu beschalten. Ein zu messendes Magnetfeld $H_N$ wirkt parallel zur Oberfläche der ein Hallelement enthaltenden integrierten Schaltung. Ein Pol $V_{DD}$ einer Speisespannung $V_{DD}$; $V_{SS}$ ist über einen Stromgenerator 21 mit dem zentralen Stromanschluss $C_1$ eines Hallelementes 22 verbunden, während der andere Pol $V_{SS}$ der Speisespan-nung $V_{DD}$; $V_{SS}$ über je einen Widerstand $R_1$ bzw. $R_2$ auf die beiden andern Stromanschlüsse $C'_2$ bzw. $C''_2$ des Hallelementes 22 geführt ist (siehe Fig. 16). Der vom Stromgenerator 21 gelieferte Speisestrom i des Hallelementes 22 halbiert sich innerhalb des Hallelementes 22 und verlässt jeweils als Strom i/2 über die beiden Widerstände $R_1$ bzw. $R_2$ das Hallelement 22.

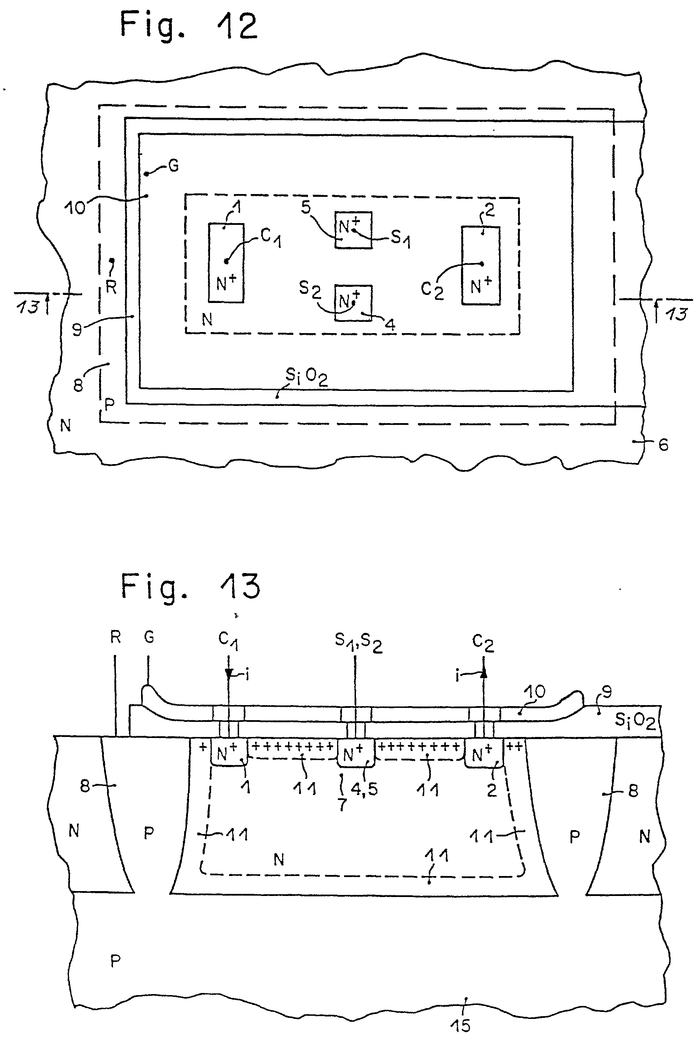

Die Figuren 12 und 13 zeigen die Draufsicht und einen vertikalen Querschnitt eines in Bi MOS-Technologie hergestellten horizontalen Hallelementes, das, einmal von der kreuzweisen Anordnung der Anschlusskontakte 1, 2, 4 und 5 abgesehen, ähnlich aufgebaut ist wie das in den Figuren 1 und 2 dargestellte vertikale Hallelement, mit dem Unterschied, dass der Ring 8 eine Bodenplatte 15 besitzt, die vom gleichen Materialleitfähigkeitstyp ist wie der Ring 8, d.h. die also aus P-Material besteht. Bedingt durch das Vorhandensein der Bodenplatte 15 umgibt die Verarmungszone 11 jetzt die aktive Zone 7 des Hallelementes nicht nur mehr seitlich und nach oben hin, sondern auch nach unten hin. In der Fig. 13 wurde angenommen, dass die Bodenplatte 15 als mechanischer Träger für das gesamte Hallelement dient.

Die Figuren 14 und 15 zeigen die Draufsicht und einen vertikalen Querschnitt eines in abgeänderter Bi-MOS-Technologie hergestellten horizontalen Hallelementes, das, einmal von der kreuzweisen Anordnung der Anschusskontakte 1, 2, 4 und 5 abgesehen, ähnlich aufgebaut ist wie das in den Figuren 6 und 7 dargestellte vertikale Hallelement, nur die vergrabene Schicht 16 fehlt beim horizontalen Hallelement. Aus den Figuren 14 und 15 ist auch ersichtlich, dass, wenn im dort dargestellten Hallelement die beiden Anschlusskontakte 4 und 5 mit ihren Sensoranschlüssen $S_1$ und $S_2$ weggelassen werden, ein Feldeffekttranisistor entsteht, der in der gleichen Technologie hergestellt ist wie das zugehörige Hallelement. Feldeffekttransistoren, z.B. der in der Fig. 17 dargestellte Feldeffekttransistor 32, und Hallelemente können somit in einer einzigen integrierten Schaltung mit gleicher Technologie eingebaut werden.

Die in der Fig. 17 dargestellte Einrichtung enthält neben einem Hallelement 22 und dem Stromgenerator 21 noch eine Regelungsschaltung 24; 25; 26; 27. In der Fig. 17 wurde angenommen, dass das Hallelement 22 eines der in den Figuren 12 bis 15 dargestellten Hallelemente ist, welche alle neben dem Ringanschluss R nur vier Strom- bzw. Sensoranschlüsse $C_1$, $C_2$, $S_1$ und $S_2$ besitzen. In diesem Fall sind die beiden Stromanschlüsse $C_1$ und $C_2$ mit je einem Pol des Stromgenerators 21 verbunden. Ist dagegen das in der Fig. 17 verwendete Hallelement 22 eines der in den Figuren 1 bis 9 dargestellten Hallelemente, welche alle neben dem Ringanschluss R noch fünf Strom- bzw. Sensoranschlüsse $C_1$, $C'_2$, $C''_2$, $S_1$ und $S_2$ besitzen, so ist, wie bereits erwähnt, die in der Fig. 16 dargestellte Beschaltung des Hallelementes zu verwenden. In beiden Fällen liegt einer der beiden Sensoranschlüsse, z.B. der zweite Sensoranschluss $S_2$, an Masse, während der andere erste Sensoranschluss $S_1$ den Ausgang $S_1$ des Hallelementes 22 bildet.

Der Gateanschluss G mit seiner Gateschicht 10 ist nur vorhanden bei Verwendung eines der in den Figuren 1 und 2 oder 12 und 13 dargestellten Hallelemente. In diesen Fällen ist der Gateanschluss G an eine vorgegebene feste Spannung zu legen. In allen Fällen, d.h. bei Verwendung eines in den Figuren 1 bis 9 oder 12 bis 15 dargestellten Hallelementes, ist der Ringanschluss R der Steuereingang M des Hallelementes 22. In allen Fällen ist eine Sperrschicht 11 bzw. 12; 7 mindestens zwischen der aktiven Zone 7 und der Oberfläche des Hallelementes 22 angeordnet und bedeckt, wie bereits erwähnt, die aktive Zone 7 des Hallelementes 22 möglichst vollständig nach oben hin.

Der Sperrschicht 11 bzw. 12; 7 isoliert und schützt vollständig die aktive Zone 7 des Hallelementes 22, so dass das Vorhandensein einer Isolierschicht aus Siliziumoxyd, die einen unmittelbaren direkten Kontakt hat mit der aktiven Zone 7 des Hallelementes 22, überflüssig ist. Die immer in einer solchen Isolierschicht aus Siliziumoxyd enthaltene variable Anzahl von Ladungsträgern ist demnach hier nicht vorhanden und kann daher auch die Langzeitstabilität des Hallelementes 22 nicht negativ beeinflussen. Die in den Figuren 1, 2, 12 und 13 dargestellte Oxydschicht 9 aus $SiO_2$ hat nur eine sekundäre Funktion und keinen unmittelbaren direkten Kontakt mit der aktiven Zone 7 des Hallelementes 22, sondern ist von dieser aktiven Zone 7 durch die Sperrschicht 11 getrennt. Die schützende Wirkung der Sperrschicht 11 bzw. 12; 7 ist um so stärker, je vollständiger sie die aktive Zone 7 des Hallelementes 1 nach möglichst allen Richtungen hin umgibt und hängt ausserdem von ihrer Tiefe ab. Diese Tiefesollte trotz Vorhandensein von möglichen Störeinflüssen, z.B. von veränderlichen Temperatureinflüssen, immer konstant sein. Um dies zu erreichen ist das Hallelement 22, wie in der Fig. 17 dargestellt, mit einer Regelungsschaltung 24; 25; 26; 27 zu beschalten, welche die Tiefe der Sperrschicht 11 bzw. 12;7 auf einen konstanten Wert regelt.

In der Fig. 17 ist der Ausgang $S_1$ des Hallelementes 22 über die Regelungsschaltung 24; 25; 26; 27 mit dem Steuereingang M des Hallelementes 22 verbunden. Die Regelungsschaltung 24; 25; 26; 27 besteht mindestens aus einem Istwertaufbereiter 24, einem Sollwertgeber 25 und einem Sollwert/Istwert-Differenzgeber 26; 27. Der Ausgang $S_1$ des Hallelementes 22 ist über den Istwertaufbereiter 24 mit einem Eingang $E_1$ des Sollwert/Istwert-Differenzgebers 26; 27 und der Ausgang des Sollwertgebers 25 direkt mit dessem zweiten Eingang $E_2$ verbunden. Der Ausgang des Sollwert/Istwert-Differenzgebers 26; 27 ist auf den Steuereingang M des Hallelementes 22 geführt. Der Istwertaufbereiter 24 ist im einfachsten Fall ein Absolutwertbildner, z.B. ein Gleichrichter, dessen Ausgangsspannung immer gleich dem Absolutwert seiner Eingangsspannung ist.

In der Fig. 17 besteht der Absolutwertbildner und damit auch der Istwertaufbereiter 24 mindestens aus einem von einem Steuergerät 28 gesteuerten Umschalter 29 und aus einem invertierenden Verstärker 30. In der Fig. 17 besitzt der Istwertaufbereiter 24 noch zur Entkopplung einen Spannungsfolger 31, der fakultativ vorhanden ist. Innerhalb des Istwertaufbereiters 24 ist dessen Eingang direkt oder über den Spannungsfolger 31, je nach Stellung des Umschalters 29, durch diesen Umschalter 29 entweder mit dem Eingang oder mit dem Ausgang des invertierenden Verstärkers 30 verbunden. Der Ausgang des invertierenden Verstärkers 30 bildet den Ausgang des Istwertaufbereiters 24 und ist demnach auf den Eingang $E_1$ des Sollwert/Istwert-Differenzgebers 26; 27 geführt. Der Eingang des Istwertaufbereiters 24 ist ausserdem noch direkt oder über den Spannungsfolger 31 mit dem Eingang des Steuergerätes 28 verbunden, dessen Ausgang auf den Steuereingang des Umschalters 29 geführt ist. Das Steuergerät 28 besteht z.B. aus nur einem Komparator und detektiert die Polarität der Eingangsspannung des Istwert-taufbereiters 24 und damit auch die Polarität dieser Ausgangsspannung $V_H$ des Hallelementes 22. Je nach Polarität dieser Ausgangsspannung $V_H$ überbrückt oder nimmt der Umschalter 29 den invertierenden Verstärker 30 in Betrieb. Mit andern Worten: Ist die ausgangsspannung $V_H$ des Hallelementes 22 positiv, wird sie direkt ohne Vorzeichen-Invertierung, und ist sie negativ, wird sie durch den ersten invertierenden Verstärker 30 mit Vorzeichen-Invertierung an den ersten Eingang $E_1$ des Sollwert/Istwert-Differenzgebers 26; 27 weitergeleitet.

Der Sollwertgeber 25 besteht z.B. aus der Reihenschaltung eines Vorwiderstandes R' und der "Source-Drain"-Strecke eines Feldeffekttransistors 32, deren gemeinsamer Pol den Ausgang des Sollwertgebers 25 bildet und somit mit dem zweiten Eingang $E_2$ des Sollwert/ Iswert-Differenzgebers 26; 27 verbunden ist. Der andere Pol des Vorwiderstandes R' liegt an einer ersten Referenzspannung $V_{ref,1}$, der "Gate"-Anschluss des Feldeffekttransistors 32 an einer zweiten Referenzspannung $V_{Ref,2}$ und der andere Pol der "Source-Drain"-Strecke des Feldeffekttransistors 32 an einer dritten Referenzspan-nung $V_{Ref,3}$.

Der Sollwert/Istwert-Differenzgeber 26; 27 besteht mindestens aus einem Differenzverstärker 26, der z.B. auf an sich bekannte Art mit Hilfe eines Operationsverstärkers 33 aufgebaut ist. In diesem Fall ist der invertierende Eingang des Operationsverstärkers 33 über einen ersten Eingangswiderstand $R_3$ mit dem ersten Eingang $E_1$, über einen zweiten Eingangswiderstand $R_4$ mit dem zweiten Eingang $E_2$ und über einen Rückkopplungswiderstand $R_5$ mit dem Ausgang F jeweils des Differenzverstärkers 26 verbunden. Dieser Ausgang F ist gleichzeitig auch der Ausgang des Operationsverstärkers 33. Der nichtinvertierende Eingang des Operationsverstärkers 33 liegt über einen dritten Eingang $E_3$ des Differenz-verstärkers 26 an einer vierten Referenzspannung $V_{Ref,4}$. Der Differenzverstärker 26 ist somit als invertierender Verstärker beschaltet. Ein weiterer Verstärker 27 ist ihm in Kaskade nachgeschaltet, z.B. zwecks Rückgängigmachung der durch den Differenzverstärker 26 verursachten Invertierung. Die beiden Verstärker 27 und 30 besitzen z.B. je einen Verstärkungsfaktor -1 und sind z.B. ebenfalls mit je einem Operationsverstärker auf an sich bekannte Art aufgebaut.

Der Feldeffekttransistor 32 dient als temperaturempfindliches Element, dessen Sättigungs ("Pinch off") -Strom umgekehrt proportional dem Quadrat der Umgebungstemperatur des Feldeffekttransistors 32 und auch des Hallelementes 22 ist, da diese beiden Bauelemente, dank ihres Einbaus in einer integrierten Schaltung, räumlich sehr nahe beieinander liegen. Dies zeigt wiederum, wie wichtig es ist, dass sowohl das Hallelement 22 als auch Transistoren, wie z.B. der Feldeffekttransistor 32, im gleichen Halbeiter-Kristall mit Hilfe der gleichen Technologie integrierbar sind.

Die Regelungsschaltung 24; 25; 26; 27 regelt die Dicke der Sperrschicht 11 bzw. 12; 7, indem sie die Ausgangsspannung des Hallelementes 22 als Istwert mit dem vom Sollwertgeber 25 gelieferten Sollwert vergleicht und eine so erhaltene Sollwert/Istwert-Differenz verstärkt auf den Steuereingang M des Hallelementes 22 gibt. Da der Feldeffekttransistor 32 ein temperaturempfindliches Bauelement ist, ist auch der Sollwert temperaturabhängig. Dies gestattet es der Regelungsschaltung 24; 25; 26; 27, in diesem Fall die Dicke der Sperrschicht 11 bzw. 12; 7 auf einen Wert zu regeln, der es ermöglicht, dass die Magnetfeld-Empfindlichkeit des Hallelementes 22 unabhängig von der Temperatur bleibt. Ist das Hallelement 22 von sich aus genügend temperaturstabil, so ist der Feldeffekttransistor 32 überflüssig und kann weggelassen werden.

Der Umschalter 29 ist als Relaiskontakt in der Fig. 17 dargestellt. In der Praxis ist er jedoch in der Regel ein steuerbarer Halbleiter-Umschalter, der z.B. in CMOS-Technologie hergestellt ist.

Die in der Fig. 17 dargestellte Schaltung hat ausserdem noch den Vorteil, die Kennlinie $V_H = f(B)$ des Hallelementes 22 bei gegebenem Speisestrom i zu linearisieren, wobei sowohl geradpaarige als auch ungeradpaarige Nichtlinearitäten behoben werden. Die Definition der Nichtlinearität ist aus der Fig. 18 ersichtlich, in der eine nichtlineare Kennlinie $V_H = f(B)$ für einen gegebenen Speisestrom i dargestellt ist. Die linearisierte Kennlinie ist in der Fig. 18 gestrichelt wiedergegeben. Bei einem bestimmten Wert $B = B_1$ der Induktion B besitzt die nichtlineare Kennlinie der Hallausgangsspannung $V_H$ einen Arbeitspunkt X, dessen Ordinate gleich $V_H(B_1)$ ist, während der entsprechende Arbeitspunkt Y auf der linearen Kennlinie

$$\text{die Ordinate} \left[\frac{\partial V_H}{\partial B}\right]_{B=0} \cdot B_1 \text{ hat, wobei der Faktor} \left[\frac{\partial V_H}{\partial B}\right]_{B=0}$$

sowohl die Steigung der nichtlinearen als auch die Steigung der linearen Kennlinie im Nullpunkt $B = 0$ dar-stellt. Die Nichtlinearität $\varepsilon(B_1)$ beim Wert $B = B_1$ ist definiert als Differenz der beiden Ordinaten der Arbeitspunkte Y und X. D.h.:

$$\varepsilon(B_1) = \left[\frac{\partial V_H}{\partial B}\right]_{B=0} \cdot B_1 - V_H(B_1).$$

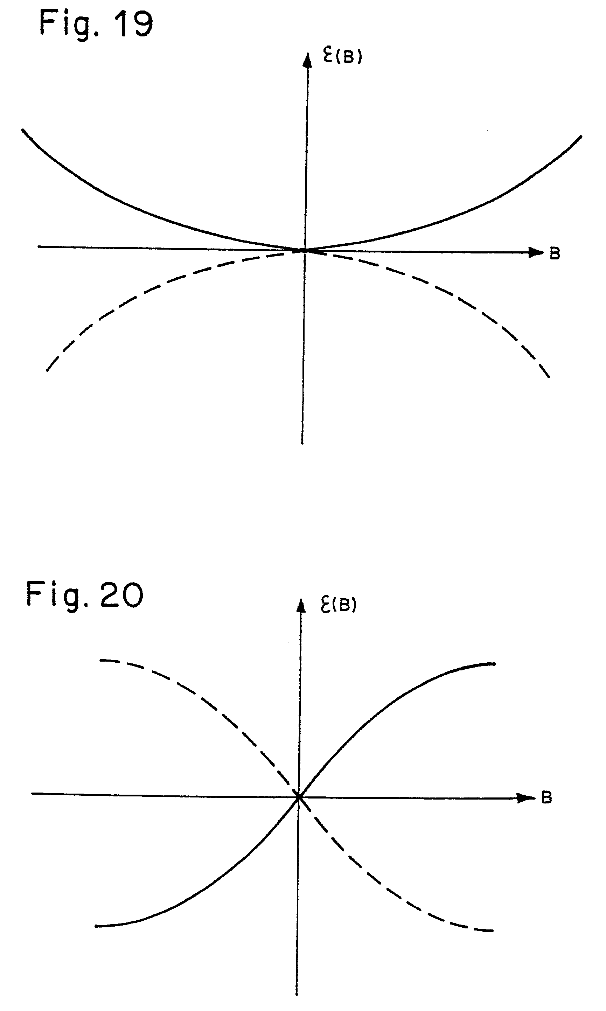

Die nichtlinearität ist vom geradpaarigen Typ, wenn:
$\varepsilon(B_1) = \varepsilon(-B_1)$ (siehe Fig. 19).
Die Nichtlinearität ist vom ungeradpaarigen Typ, wenn:
$\varepsilon(B_1) = -\varepsilon(-B_1)$ (siehe Fig. 20).
Die in der Fig. 18 dargestellte Nichtlinearität ist vom ungeradpaarigen Typ.

Ob die Nichtlinearität eines gegebenen Hallelementes 22 von geradpaarigen oder vom ungeradpaarigen Typ ist, muss vor dem Einbau des Hallelementes 22 in der in der Fig. 17 dargestellten Schaltung mit Hilfe z.B. einer Messung ermittelt werden. Die nachfolgende Funktionsbeschreibung gilt unter der Annahme, dass den positiven Werten der Induktion B auch positive Werte der Ausgangsspannung $V_H$ des Hallelementes 22 und den negativen Werten der Induktion B auch negative Werte der Ausgangsspannung $V_H$ entsprechen (siehe Fig. 18).

Bei einem Hallelement vom geradpaarigen Typ ist in der Regel die Nichtlinearität $\varepsilon(B)$ in Funktion der Induktion B entweder immer positiv, wie in der Fig. 19 als nichtgestrichelte Kennlinie dargestellt, oder immer negativ, wie in der Fig. 19 als gestrichelte Kennlinie dargestellt.

Bei einem Hallelement vom ungeradpaarigen Typ ist in der Regel die Nichtlinearität $\varepsilon(B)$ in Funktion der Induktion B entweder, wie in der Fig. 20 als nichtgestrichelte Kennlinie dargestellt, für positive Werte von B positiv und für negative Werte von B negativ, oder umgekehrt, wie in der Fig. 20 als gestrichelte Kennlinie dargestellt, für positive Werte von B negativ und für negative Werte von B positiv.

Ist das Hallelement 22 in idealer Weise vom geradpaarigen Typ, dann wird der vierte Eingang $E_4$ des Differenzverstärkers 26 nicht benutzt, d.h. die in der Fig. 17 gestrichelt gezeichnete fakultative Verbindung zwischen Ausgang des Spannungsfolgers 31 und vierten Eingang $E_4$ des Differenzverstärkers 26 fällt weg und nur der Absolutwert der Ausgangsspannung $V_H$ des Hallelementes 22 erreicht über den Istwertaufbereiter 24 den ersten Eingang $E_1$ des Differenzverstärkers 26.

Besitzt in diesem Fall das Hallelement 22 eine ähnliche Kennlinie wie diejenige, die in der Fig. 19 nichtgestrichelt ist, und unter der Voraussetzung, dass der Spannungsfolger 31 einen positiven Verstärkungsfaktor +1 besitzt, muss der Verstärker 27 ein invertierender Verstärker sein, so dass die Kaskadenschaltung 24; 26 ; 27 keine Spannungsinversion verursacht. Besitzt das Hallelement 22 dagegen eine ähnliche Kennlinie wie diejenige, die in der Fig. 19 gestrichelt dargestellt ist, muss der Verstärker 27 unter gleichen Voraussetzungen ein nichtinvertierender Verstärker sein, so dass die Kaskadenschaltung 24; 26; 27 eine Spannungsinversion verursacht.

Ist das Hallelement 22 in idealer Weise vom ungeradpaarigen Typ, dann können das Steuergerät 28, der Umschalter 29 und der invertierende Verstärker 30 weggelassen werden, d.h. es wird kein Absolutwert der Ausgangsspannung $V_H$ des Hallelementes 22 gebildet und diese Ausgangsspannung $V_H$ erreicht über den Spannungsfolger 31 und einer fakultativ vorhandenen, daher in der Fig. 17 gestrichelt dargestellten Verbindung einen vierten Eingang $E_4$ des Differenzverstärkers 26. Im letzteren ist der vierte Eingang $E_4$ über einen dritten Eingangswiderstand $R_6$ mit dem invertierenden Eingang des Operationsverstärkers 33 verbunden.

Besitzt in diesem Fall das Hallelement 22 eine ähnliche Kennlinie wie diejenige, die in der Fig. 20 nichtgestrichelt dargestellt ist, und wieder unter der Voraussetzung, dass der Spannungsfolger 31 einen positiven Verstärkungsfaktor +1 besitzt, muss der Verstärker 27 ein invertierender Verstärker sein, so dass die Kaskadenschaltung 31; 26; 27 keine Spannungsinversion verursacht. Besitzt das Hallelement 22 dagegen eine ähnliche Kennlinie wie diejenige, die in der Fig. 20 gestrichelt dargestellt ist, muss der Verstärker 27 unter gleichen Voraussetzungen ein nichtinvertierender Verstärker sein, so dass die Kaskadenschaltung 31; 26; 27 eine Spannungsinversion verursacht.

Die in den Figuren 19 und 20 dargestellten Kennlinien sind ideale Kennlinien. In der Praxis sind diese Kennlinien nicht so symmetrisch zur $\varepsilon(B)$-Achse bzw. zum Nullpunkt angeordnet, d.h., in der Praxis ist in der Regel immer eine Mischung von Gleichpaarigkeit und Ungleichpaarigkeit vorhanden. In diesem Fall muss die Ausgangsspannung $V_H$ des Hallelementes 22 sowohl den ersten Eingang $E_1$ über den Istwertaufbereiter 24, als auch den vierten Eingang $E_4$ über den Spannungsfolger 31 erreichen. Da die Unsymmetrien bei gleichpaarigen und bei ungleichpaarigen Nichtlinearitäten nicht unbedingt gleich gross sind, können sie durch die Wahl unterschiedlicher Werte der Eingangswiderstände $R_3$ und $R_6$ ungleich stark korrigiert werden. Der erste und der vierte Eingang $E_1$ und $E_4$ des Differenzverstärkers 26 bilden somit je einen von zwei Istwerteingängen. Am vierten Eingang $E_4$ erscheint immer die Ausgangsspannung $V_H$ des Hallelementes 22 mit ihrem wirklichen Vorzeichen, während am ersten Eingang $E_1$ des Differenzverstärkers 26 immer der Absolutwert dieser Ausgangsspannung vorhanden ist. Die Summe der beiden an den beiden Eingängen $E_1$ und $E_4$ des Differenzverstärkers 26 anliegenden Spannungen bildet hier den Istwert der Regelungsschaltung 24; 25; 26; 27.

Kurz zusammengefasst kann die Arbeitsweise der in der Fig. 17 dargestellten Schaltung wie folgt beschrieben werden:
Die Referenzspannungen $V_{Ref,1}$, $V_{Ref,2}$, $V_{Ref,3}$ und $V_{Ref,4}$ werden so gewählt, dass am Eingang des Verstärkers 27 ein positiver Sollwert ansteht, wenn der Verstärker 27 invertierend ist, und umgekehrt ein negativer Sollwert ansteht, wenn der Verstärker 27 nichtinvertierend ist, so dass in beiden Fällen am Steuereingang M des Hallelementes 22 eine negative Grundspannung als Sollwert ansteht. Ist das mittels des Hallelementes 22 gemessene Magnetfeld z.B. ein sinusförmiges Wechselmagnetfeld, so ist die

Ausgangspannung $V_H$ des Hallelementes 22 eine sinusförmige Wechselspannung. Bei einem Hallelement 22 mit idealer ungeradpaariger Nichtlinearität wird diese sinusförmige Wechselspannung $V_H$ unverändert dem vierten Eingang $E_4$ des Differenzverstärkers 26 als Istwert zugeführt und anschliessend, je nach positivem oder negativem Verstärkungsfaktor des Verstärkers 27 dem konstanten Sollwert mit oder ohne Inversion so überlagert, dass die negative Spannung am Steuereingang M des Hallelementes 22 in der richtigen Richtung weniger bzw. mehr negativ wird, wobei die Gesamtspannung am Steuereingang M auf jeden Fall negativ bleiben muss.

Bei einem Hallelement 22 mit idealer geradpaariger Nichtlinearität geschieht dasselbe, nur dass diesmal die negativen Halbwellen der Ausgangspannung $V_H$ des Hallelementes 22 mit Hilfe des Umschalters 29 und des invertierenden Verstärkers 30 gleichgerichtet werden und die so gleichgerichtete Ausgangspannung $V_H$ als Istwert dem ersten Eingang $E_1$ des Differenzverstärkers 26 zugeführt wird. Ist der Verstärkungsfaktor des invertierenden Verstärkers 30 gleich -1, dann sind die gleichgerichteten negativen Halbwellen gleich gross wie die positiven Halbwellen, andernfalls ungleichgross. Bei einem Hallelement 22 mit unsymmetrischen Nichtlinearitäten, d.h. wenn eine Kombination geradpaariger und ungeradpaariger Nichtlinearitäten vorhanden ist, muss auch der Istwert eine Kombination der beiden obenerwähnten Istwerte sein, d.h. die unveränderte Ausgangspannung $V_H$ muss dem Eingang $E_4$ und die gleichgerichte Ausgangspannung $V_H$ muss dem Eingang $E_1$ gleichzeitig zugeführt werden. In deisem Fall wird die Summe der gewichteten Ausgangspannung $V_H$ und der gewichteten gleichgerichteten Ausgangspannung $V_H$ als Gesamtistwert wirksam, wobei die Werte der Eingangswiderstände $R_6$ bzw. $R_3$ jeweils den Gewichtsfaktor bilden.

Da bei einem gegebenen Magnetfeld die Empfindlichkeit und damit auch die Ausgangspannung $V_H$ des Hallelementes 22 annähernd umgekehrt proportional zur Dicke der Sperrschicht ist und diese Dicke anderseits proportional der Spannung ist, die am Steuereingang M ansteht, wird die Nichtlinearität der Ausgangspannung $V_H$ korrigiert, wenn die Spannung am Steuereingang M des Hallelementes 22 regelungstechnisch in der richtigen Richtung verändert wird.

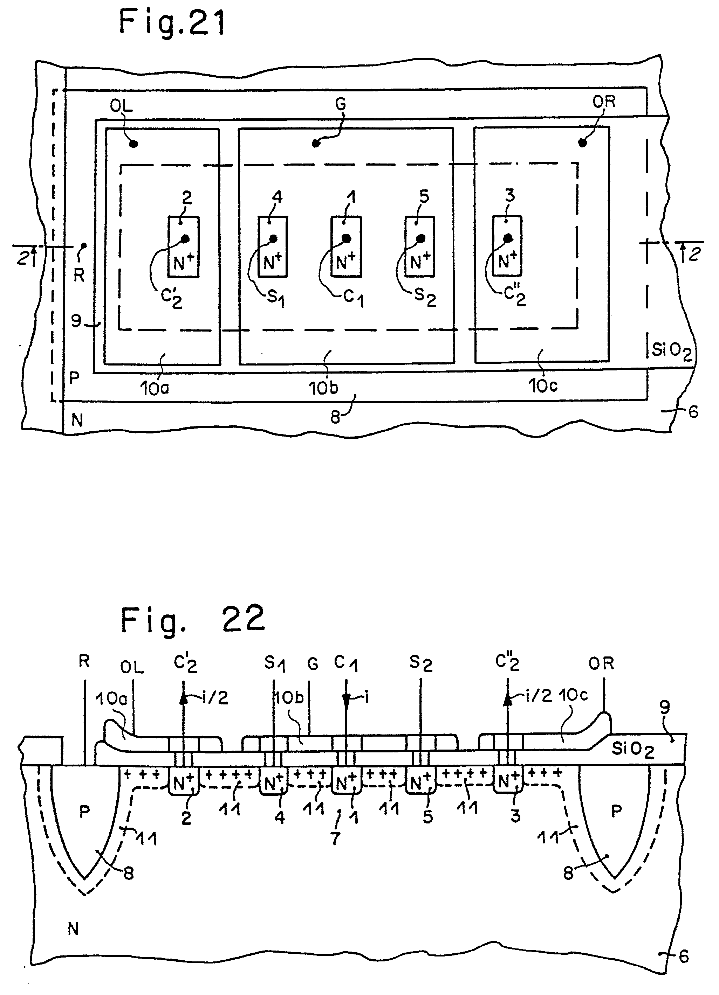

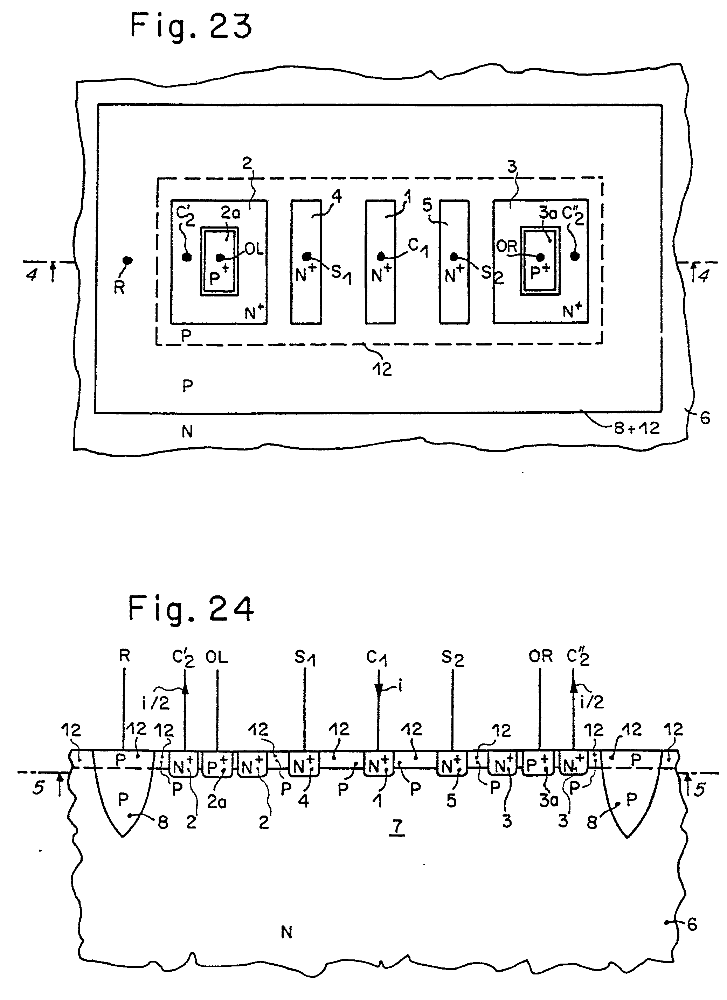

Die Fig. 21 entspricht annähernd der Fig. 1 und die Fig. 22 annähernd der Fig. 2, mit dem einzigen Unterschied, dass in den beiden Figuren 1 und 2 die elektrisch leitende Gateschicht 10 durch drei parallel nebeneinander angeordnete und voneinander getrennte Gateschichten 10a, 10b und 10c ersetzt worden ist. Die mittlere Gateschicht 10b deckt vollständig nach oben hin den Teil der aktiven Zone 7 ab, in der die Anschlusskontakte 1, 4 und 5 enthalten sind, und besitzt einen Gateanschluss G. Die in der Darstellung der Zeichnung linke Gateschicht 10a deckt vollständig nach oben hin den Teil der aktiven Zone 7 ab, in der der Anschlusskontakt 2 enthalten ist, und besitzt einen Gateanschluss OL. Die in der Darstellung der Zeichnung rechte Gateschicht 10c deckt vollständig nach oben hin den Teil der aktiven Zone 7 ab, in der der Anschlusskontakt 3 enthalten ist, und besitzt einen Gateanschluss OR.

Die Fig. 23 entspricht annähernd der Fig. 3 und die Fig. 24 annähernd der Fig. 4, mit dem Unterschied, dass die beiden äusseren Strom-Anschlusskontakte 2 und 3 rechteckig ringförmig sind und jeweils eine Kontaktregion 2a bzw. 3a eines Gateanschlusses OL bzw. OR seitlich umgeben, wobei die beiden Kontaktregionen 2a und 3a der Gateanschlüsse OL und OR stark mit Fremdatomen dotiert und vom entgegengesetzten Materialleitfähigkeitstyp P sind wie die Anschlusskontakte 2 und 3, d.h. sie bestehen aus P+-Material, wenn die Anschlusskontakte 2 und 3 aus N+-Material bestehen.

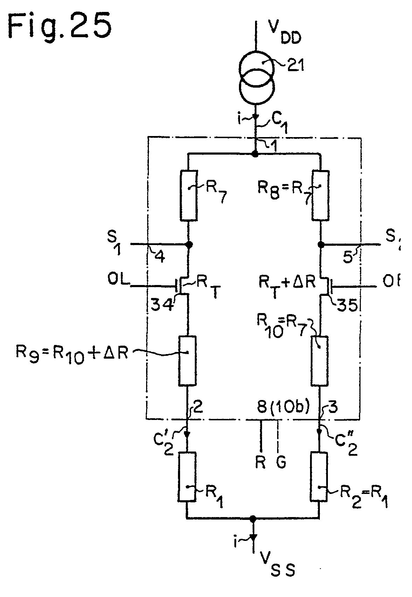

Das in den Figuren 21 und 22 bzw. 23 und 24 dargestellte Hallelement ist extern ähnlich zu beschalten wie das Hallelement 22 in der Fig. 16, nur dass nun noch zwei zusätzliche Gateanschlüsse OL und OR vorhanden sind, die der Kompensation der Nullspannung ("Offset"-Spannung) des Hallelementes dienen. Das Ersatzschaltbild des Hallelementes besteht jetzt gemäss der Fig. 25 aus vier Widerständen $R_7$, $R_8$, $R_9$ und $R_{10}$ sowie aus zwei Feldeffekttransistoren 34 und 35, deren Gateanschluss jeweils der Gateanschluss OL bzw. OR des Hallelementes ist. Der Widerstand $R_7$, die "Source-Drain"-Strecke des Feldeffekttransistors 34 und der Widerstand $R_9$ sind in der angegebenen Reihenfolge in Reihe geschaltet, desgleichen der Widerstand $R_8$, die "Source-Drain"-Strecke des Feldeffekttransistors 35 und der Widerstand $R_{10}$. Die beiden freien Enden der Widerstände $R_7$ und $R_8$ sind miteinander verbunden und bilden den Anschlusskontakt 1 des Hallelementes, der vom externen Stromgenerator 21, genau wie in der Fig. 16, mit dem Strom i gespeist wird. Der freie Anschluss des Widerstandes $R_9$ bildet den Anschlusskontakt 2 und der freie Anschluss des Widerstandes $R_{10}$ den Anschlusskontakt 3 des Hallelementes. Die beiden Anschlusskontakte 2 und 3 sind, genau wie in der Fig. 16, extern über je einen Widerstand $R_1$ bzw. $R_2$ mit dem Pol $V_{SS}$ der Speisespannung $V_{DD};V_{SS}$ verbunden, während ein zweiter Pol des Stromgenerators 21 auf deren Pol $V_{DD}$ geführt ist. Der gemeinsame Anschluss des Widerstandes $R_7$ und des Feldeffekttransistors 34 bildet den ersten Sensor-Anschluss $S_1$ und der gemeinsame Anschluss des Widerstandes $R_8$ und des Feldeffekttransistors 35 den zweiten Sensor-Anschluss $S_2$ des Hallelementes. Es gilt $R_1 = R_2$ und $R_7 = R_8$. Bei einem idealen Hallelement ohne Nullspannung ("Offset"-Spannung) gilt ausserdem $R_9 = R_{10}$ mit $R_{10} = R_7$. Die "Source-Drain"-Widerstände der beiden Feldeffekttransistoren 34 und 35 sind ebenfalls gleich und mit $R_T$ bezeichnet, wenn an den beiden Gateanschlüssen OL und OR eine gleiche elektrische Spannung ansteht.

Bei nichtidealen Hallelemente mit vorhandener Nullspannung ("Offset"-Spannung) gilt z.B. $R_9 = R_{10} + \Delta R$, d.h. die Messbrücke $R_7;34;R_9; R_1;R_2;R_{10}; 35;R_8$ ist unsymmetrisch und es ensteht bei abwesendem

Magnetfeld am Ausgang S₁;S₂ des Hallelementes eine von Null unterschiedliche Ausgangsspannung. Diese kann dadurch kompensiert werden, dass die Spannung am Gateanschluss OR des Feldeffekttransistors 35 derart geändert wird, dass dessen "Source-Drain"-Strecke einen Widerstand $R_T + \Delta R$ annimmt. Dadurch wird die Messbrücke wieder symmetrisch, da das $\Delta R$ des Widerstandes $R_9$ durch das $\Delta R$ der "Source-Drain"-Strecke des Feldeffekttransistors 35 kompensiert wird. Die Spannung am Ausgang S₁;S₂ des Hallelementes wird somit korrekterweise wieder Null bei abwesendem Magnetfeld. D.h. die Nullspannung des Hallelementes kann mit Hilfe der an den beiden Gateanschlüssen OR und OL des Hallelementes anstehenden elektrischen Spannungen kompensiert werden.

**Patentansprüche für die Vertragsstaaten: AT, BE, CH, LI, SE**

1. Einrichtung mit einem in einer integrierten Schaltung integrierbaren Hallelement, das zwei Sensor-Anschlusskontakte und mindestens zwei Strom-Anschlusskontakte besitzt, die an der Oberfläche im Hallelement angeordnet sind, dadurch gekennzeichnet, dass mindestens zwischen der aktiven Zone (7) des Hallelementes (22) und der Oberfläche des Hallelementes (22) eine Sperrschicht (11 bzw. 12;7)angeordnet ist, die die aktive Zone (7) des Hallelementes (22) nach oben hin abdeckt.

2. Einrichtung nach Anspruch 1, dadurch gekennzeichnet, dass der Ausgang (S₁) des Hallelementes (22) über eine Regelungsschaltung (24; 25; 26; 27) mit einem die Dicke der Sperrschicht (11 bzw. 12; 7) steuernden Steuereingang (M) des Hallelementes (22) verbunden ist.

3. Einrichtung nach Anspruch 2, dadurch gekennzeichnet, dass die Regelungsschaltung (24; 25; 26; 27) mindestens aus einem Istwertaufbereiter (24), einem Sollwertgeber (25) und einem Sollwert/Istwert-Differenzgeber (26; 27) besteht.

4. Einrichtung nach Anspruch 3, dadurch gekennzeichnet, dass der Istwertaufbereiter (24) ein Absolutwertbildner ist.

5. Einrichtung nach Anspruch 4, dadurch gekennzeichnet, dass der Istwertaufbereiter (24) mindestens aus einem von einem Steuergerät (28) gesteuerten Umschalter (29) und aus einem invertierenden Verstärker (30) besteht.

6. Einrichtung nach Anspruch 5, dadurch gekennzeichnet, dass das Steuergerät (28) aus einem Komparator besteht.

7. Einrichtung nach Anspruch 4, dadurch gekennzeichnet, dass der Istwertaufbereiter (24) aus einem Gleichrichter besteht.

8. Einrichtung nach einem der Ansprüche 3 bis 7, dadurch gekennzeichnet, dass der Sollwertgeber (25) aus der Reihenschaltung eines Vorwiderstandes (R') und der "Source-Drain"-Strecke eines Feldeffekttransistors (32) besteht.

9. Einrichtung nach einem der Ansprüche 3 bis 8, dadurch gekennzeichnet, dass der Sollwert/Istwert-Differenzgeber (26; 27) mindestens aus einem Differenzverstärker (26) besteht.

10. Einrichtung nach Anspruch 9, dadurch gekennzeichnet, dass der Differenzverstärker (26) als invertierender Verstärker beschaltet ist und ihm ein weiterer invertierender Verstärker (27) in Kaskade nachgeschaltet ist.

11. Einrichtung nach Anspruch 9 oder 10, dadurch gekennzeichnet, dass der Differenzverstärker (26) zwei Istwerteingänge (E₁, E₄) besitzt, wovon der erste (E₁) mit dem Ausgang und der andere (E₄) mit dem Eingang des Istwertaufbereiters (24) verbunden ist.

12. Einrichtung nach einem der Ansprüche 1 bis 11, dadurch gekennzeichnet, dass die Sperrschicht (11) gebildet ist durch eine Verarmungszone, die erzeugt ist durch elektrostatische Influenz mit Hilfe einer elektrischen Spannung, die über einen Gateanschluss (G) an einer elektrisch leitenden Gateschicht (10) anliegt, dass die Gateschicht (10) getrennt durch eine Oxydschicht (9) auf der Oberfläche des Hallelementes (22) so angeordnet ist, dass die Gateschicht (10) und damit auch die Verarmungszone die aktive Zone (7) des Hallelementes (22) nach oben hin abdeckt, und dass der Ringanschluss (R) eines Ringes (8), der die aktive Zone (7) des Hallelementes (22) mindestens seitlich umgibt und der vom entgegengesetzten Materialleitfähigkeitstyp ist wie die aktive Zone (7) des Hallelementes (22), einen Steuereingang (M) des Hallelementes (22) bildet.

13. Einrichtung nach einem der Ansprüche 1 bis 11, dadurch gekennzeichnet, dass die Sperrschicht (12; 7) gebildet ist durch die Grenzschicht zwischen der aktiven Zone (7) des Hallelementes (22) und einer an der Oberfläche im Hallelement (22) angeordneten Schicht (12), die vom entgegengesetzten Materialleitfähigkeitstyp (P) ist wie die aktive Zone (7) des Hallelementes (22) und die diese aktive Zone (7) nach oben hin abdeckt, und dass die Schicht (12) elektrischen Kontakt hat zu einem Ringanschluss (R), der einen Steuereingang (M) des Hallelementes (22) bildet.

14. Einrichtung nach Anspruch 13, dadurch gekennzeichnet, dass alle Strom- und Sensor-Anschlusskontakte (1 bis 5) des Hallelementes (22) in einer gleichen Richtung länglich sind, dass ein mit dem Ringanschluss (R) versehener Ring (8) vorhanden ist, der die aktive Zone (7) des Hallelementes (22) mindestens seitlich umgibt, vom entgegengesetzten Materialleitfähigkeitstyp ist wie die aktive Zone (7) des Hallelementes (22) und durch Zwischenstege (13, 14), die annähernd senkrecht zur Längsrichtung der Strom- und Sensor-Anschlusskontakte (1 bis 5) verlaufen, in Unterringe (I, II, III) unterteilt ist. die alle, senkrecht zur Längsrichtung der Strom- und Sensor-Anschlusskontakte (1 bis 5), eine annähernd gleiche Breite besitzen und die alle in dieser Längsrichtung, ohne gegenseitige Verschiebung, übereinander angeordnet sind, wobei zwei benachbarte Unterringe (I und II bzw. II und III) jeweils einen gemeinsamen Zweischensteg (13 bzw. 14) besitzen, und dass alle Strom- und Sensor-Anschlusskontakte (1 bis 5) genügend lang sind, um alle Schichten zu überbrücken, die von den Unterringen (I, II, III) umgeben sind.

15. Einrichtung nach Anspruch 12, dadurch gekennzeichnet, dass die elektrisch leitende Gateschicht (10) durch drei parallel nebeneinander angeordnete und voneinander getrennte Gateschichten (10a, 10b, 10c) gebildet ist, wobei die mittlere Gateschicht (10b) den Teil der aktiven Zone (7) nach oben hin abdeckt, in der drei mittlere Anschlusskontakte (1, 4, 5) des Hallelementes enthalten sind, dass die beiden andern Gateschichten (10a, 10c) je einen Teil der aktiven Zone (7) nach oben hin abdecken, in dem je ein weiterer Anschlusskontakt (2, 3) des Hallelementes enthalten ist, und dass alle drei Gateschichten (10a, 10b, 10c) je einen Gateanschluss (G, OL, OR) besitzen.

16. Einrichtung nach Anspruch 13, dadurch gekennzeichnet, dass die beiden äusseren Anschlusskontakte (2, 3) ringförmig sind und jeweils eine Kontaktregion (2a bzw. 3a) eines Gateanschlusses (OL bzw. OR) seitlich umgeben, wobei die Kontaktregionen (2a, 3a) der Gateanschlüsse (OL, OR) stark mit Fremdatomen dotiert und vom entgegengesetzten Materialleitfähigkeitstyp (P) sind wie die beiden äusseren Anschlusskontakte (2, 3).

17. Verwendung der Einrichtung nach einem der Ansprüche 1 bis 16 in einem Leistungsmesser oder in einem Elektrizitätszähler zum Messen eines elektrischen Stromes oder zur Bildung eines Spannung/Strom-Produktes.

## Patenansprüche für DE, FR, GB, IT, NL

1. Einrichtung mit einem in einer integrierten Schaltung integrierbaren Hallelement (22), das zwei Sensor-Anschlußkontakte (4, 5) und mindestens zwei Strom-Anschlußkontakte (1, 2 bzw. 1, 2, 3) besitzt, die an der Oberfläche im Hallelement (22) angeordnet sind, dadurch gekennzeichnet, daß mindestens zwischen der aktiven Zone (7) des Hallelementes (22) und der Oberfläche des Hallelementes (22) eine Sperrschicht (11) angeordnet ist, die die aktive Zone (7) des Hallelementes (22) nach oben hin abdeckt, daß die Sperrschicht (11) gebildet ist durch eine Verarmungszone, die erzeugt ist durch elektrostatische Influenz mit Hilfe einer elektrischen Spannung, die über einen Gateanschluß (G) an einer elektrisch leitenden Gateschicht (10) anliegt, und daß die Gateschicht (10) getrennt durch eine Oxydschicht (9) auf der Oberfläche des Hallelementes (22) so angeordnet ist, daß die Gateschicht (10) und damit auch die Verarmungszone die aktive Zone (7) des Hallelementes (22) nach oben hin abdeckt.

2. Einrichtung nach Anspruch 1, dadurch gekennzeichnet, daß der Ringanschluß (R) eines Ringes (8), der die aktive Zone (7) des Hallelementes (22) mindestens seitlich umgibt und der vom entgegengesetzten Materialleitfähigkeitstyp ist wie die aktive Zone (7) des Hallelementes (22), einen Steuereingang (M) des Hallelementes (22) bildet.

3. Einrichtung mit einem in einer integrierten Schaltung integrierbaren Hallelement (22), das zwei Sensor-Anschlußkontakte (4, 5) und mindestens zwei Strom-Anschlußkontakte (1, 2 bzw. 1, 2, 3) besitzt, die an der Oberfläche im Hallelement (22) angeordnet sind, dadurch gekennzeichnet, daß mindestens zwischen der aktiven Zone (7) des Hallelementes (22) und der Oberfläche des Hallelementes (22) eine Sperrschicht (12; 7) angeordnet ist, die die aktive Zone (7) des Hallelementes (22) nach oben hin abdeckt, daß die Sperrschicht (12; 7) gebildet ist durch die Grenzschicht zwischen der aktiven Zone (7) des Hallelementes (22) und einer an der Oberfläche im Hallelement (22) angeordneten Schicht (12), die vom entegengesetzten Materialleitfähigkeitstyp (P) ist wie die aktive Zone (7) des Hallelementes (22) und die diese aktive Zone (7) nach oben hin abdeckt, und daß die Schicht (12) elektrischen Kontakt hat zu einem Ringanschluß (R), der einen Steuereingang (M) des Hallelementes (22) bildet.

4. Einrichtung mit einem in einer integrierten Schaltung integrierbaren Hallelement (22), das zwei Sensor-Anschlußkontakte (4, 5) und mindestens zwei Strom-Anschlußkontakte (1, 2, 3) besitzt, die an der Oberfläche im Hallelement (22) angeordnet sind, dadurch gekennzeichnet, daß mindestens zwischen der aktiven Zone (7) des Hallelementes (22) und der Oberfläche des Hallelementes (22) eine Sperrschicht (12; 7) angeordnet ist, die die aktive Zone (7) des Hallelementes (22) nach oben hin abdeckt, und daß das Hallelement (22) ein vertikales Hallelement ist.

5. Einrichtung nach einem der Ansprüche 1 bis 4, dadurch gekennzeichnet, daß der Ausgang ($S_1$) des Hallelementes (22) über eine Regelungsschaltung (24; 25; 26; 27) mit einem die Dicke der Sperrschicht (11 bzw. 12; 7) steuernden Steuereingang (M) des Hallelementes (22) verbunden ist.

6. Einrichtung nach Anspruch 5, dadurch gekennzeichnet, daß die Regelungsschaltung (24; 25; 26; 27) mindestens aus einem Istwertaufbereiter (24), einem Sollwertgeber (25) und einem Sollwert/Istwert-Differenzgeber (26; 27) besteht.

7. Einrichtung nach Anspruch 6, dadurch gekennzeichnet, daß der Istwertaufbereiter (24) ein Absolutwertbildner ist.

8. Einrichtung nach Anspruch 7, dadurch gekennzeichnet, daß der Istwertaufbereiter (24) mindestens aus einem von einem Steuergerät (28) gesteuerten Umschalter (29) und aus einem invertierenden Verstärker (30) besteht.

9. Einrichtung nach Anspruch 8, dadurch gekennzeichnet, daß das Steuergerät (28) aus einem Komparator besteht.

10. Einrichtung nach Anspruch 7, dadurch gekennzeichnet, daß der Istwertaufbereiter (24) aus einem Gleichrichter besteht.

11. Einrichtung nach einem der Ansprüche 6 bis 10, dadurch gekennzeichnet, daß der Sollwertgeber (25) aus der Reihenschaltung eines Vorwiderstandes (R') und der "Source-Drain"-Strecke eines Feldeffekttransistors (32) besteht.

12. Einrichtung nach einem der Ansprüche 6 bis 11, dadurch gekennzeichnet, daß der Sollwert/Istwert-Differenzgeber (26; 27) mindestens aus einem Differenzverstärker (26) besteht.

13. Einrichtung nach Anspruch 12, dadurch gekennzeichnet, daß der Differenzverstärker (26) als invertierender Verstärker beschaltet ist und ihm ein weiterer invertierender Verstärker (27) in Kaskade nachgeschaltet ist.

14. Einrichtung nach Anspruch 12 oder 13, dadurch gekennzeichnet, daß der Differenzverstärker (26) zwei Istwerteingänge ($E_1$, $E_4$) besitzt, wovon der erste ($E_1$) mit dem Ausgang und der andere ($E_4$) mit dem Eingang des Istwertaufbereiters (24) verbunden ist.

15. Einrichtung nach Anspruch 3 oder 4, dadurch gekennzeichnet, daß alle Strom- und Sensor-Anschlußkontakte (1 bis 5) des Hallelementes (22) in einer gleichen Richtung länglich sind, daß ein mit dem Ringanschluß (R) versehener Ring (8) vorhanden ist, der die aktive Zone (7) des Hallelementes (22) mindestens seitlich umgibt, vom entgegengesetzten Materialleitfähigkeitstyp ist wie die aktive Zone (7) des Hallelementes (22) und durch Zwischenstege (13, 14) die annähernd senkrecht zur Längsrichtung der Strom- und Sensor-Anschlußkontakte (1 bis 5) verlaufen, in Unterringe (I, II, III) unterteilt ist, die alle, senkrecht zur Längsrichtung der Strom- und Sensor-Anschlußkontakte (1 bis 5), eine annähernd gleiche Breite besitzen und die alle in dieser Längsrichtung, ohne gegenseitige Verschiebung, übereinander angeordnet sind, wobei zwei benachbarte Unterringe (I und II bzw. II und III) jeweils einen gemeinsamen Zwischensteg (13 bzw. 14) besitzen, und daß alle Strom- und Sensor-Anschlußkontakte (1 bis 5) genügend lang sind, um alle Schichten zu überbrücken, die von den Unterringen (I, II, III) umgeben sind.

16. Einrichtung nach Anspruch 1 oder 2, dadurch gekennzeichnet, daß die elektrisch leitende Gateschicht (10) durch drei parallel nebeneinander angeordnete und voneinander getrennte Gateschichten (10a, 10b, 10c) gebildet ist, wobei die mittlere Gateschicht (10b) den Teil der aktiven Zone (7) nach oben hin abdeckt, in der drei mittlere Anschlußkontakte (1, 4, 5) des Hallelementes enthalten sind, daß die beiden anderen Gateschichten (10a, 10c) je einen Teil der aktiven Zone (7) nach oben hin abdecken, in dem je ein weiterer Anschlußkontakt (2, 3) des Hallelementes enthalten ist, und daß alle drei Gateschichten (10a, 10b, 10c) je einen Gateanschluß (G, OL, OR) besitzen.

17. Einrichtung nach Anspruch 3 oder 4, dadurch gekennzeichnet, daß die beiden äußeren Anschlußkontakte (2, 3) ringförmig sind und jeweils eine Kontaktregion (2a bzw. 3a) eines Gateanschlusses (OL bzw. OR) seitlich umgeben, wobei die Kontaktregionen (2a, 3a) der Gateanschlüsse (OL, OR) stark mit Fremdatomen dotiert und vom entgegengesetzten Materialleitfähigkeitstyp (P) sind wie die beiden äußeren Anschlußkontakte (2, 3).

18. Verwendung der Einrichtung nach einem der Ansprüche 1 bis 17, in einem Leistungsmesser oder in einem Elektrizitätszähler zum Messen eines elektrischen Stromes oder zur Bildung eines Spannungs/Strom-Produktes.

**Claims for DE, FR, GB, IT and NL**

1. A device comprising a Hall element (22) which can be integrated in an integrated circuit and which has two sensor connection contacts (4, 5) and at least two current connection contacts (1, 2 and 1, 2, 3) which are arranged at the surface in the Hall element (22), characterised in that arranged at least between the active zone (7) of the Hall element (22) and the surface of the Hall element (22) is a barrier layer (11) which covers the active zone (7) of the Hall element (22) in an upward direction, that the barrier layer (11) is formed by a depletion zone which is produced by electrostatic influence by means of an electrical voltage which is applied by way of a gate connection (G) to an electrically conductive gate layer (10) and that the gate layer (10) is arranged on the surface of the Hall element (22), separated by an oxide layer (9), in such a way that the gate layer (10) and therewith the depletion zone covers the active zone (7) of the Hall element (22) in an upward direction.

2. A device according to claim 1 characterised in that the ring connection (R) of a ring (8) which at least laterally surrounds the active zone (7) of the Hall element (22) and which is of opposite material conductivity type from the active zone (7) of the Hall element (22) forms a control input (M) of the Hall element (22).

3. A device comprising a Hall element (22) which can be integrated in an integrated circuit and which has two sensor connection contacts (4, 5) and at least two current connection contacts (1, 2 and 1, 2, 3) which are arranged at the surface in the Hall element (22), characterised in that arranged at least between the active zone (7) of the Hall element (22) and the surface of the Hall element (22) is a barrier layer (12; 7) which covers the active zone (7) of the Hall element (22) in an upward direction, that the barrier layer (12; 7) is formed by the interface between the active zone (7) of the Hall element (22) and a layer (12) which is arranged at the surface in the Hall element (22) and which is of opposite material conductivity type (P) from the active zone (7) of the Hall element (22) and which covers said active zone (7) in an upward direction and that the layer (12) is in electrical contact wirth a ring connection (R) which forms a control input (M) of the Hall element (22).

4. A device comprising a Hall element (22) which can be integrated in an integrated circuit and which has two sensor connection contacts (4, 5) and at least two current connection contacts (1, 2, 3) which are arranged at the surface in the Hall element (22) characterised in that arranged at least between the active zone (7) of the Hall element (22) and the surface of the Hall element (22) is a barrier layer (12; 7) which covers the active zone (7) of the Hall element (22) in an upward direction and that the Hall element (22) is a vertical Hall element.

5. A device according to one of claims 1 to 4 characterised in that the output ($S_1$) of the Hall element (22) is connected by way of a regulating circuit (24; 25; 26; 27) to a control input (M) of the Hall element (22), which controls the thickness of the barrier layer (11 or 12; 7).

6. A device according to claim 5 characterised in that the regulating circuit (24; 25; 26; 27) comprises at least an actual value generator (24), a reference value generator (25) and a reference value/actual value differencing means (26; 27).

7. A device according to claim 6 characterised in that the actual value generator (24) is a means for forming an absolute value.

8. A device according to claim 7 characterised in that the actual value generator (24) comprises at least a change-over switch (29) controlled by a control device (28), and an inverting amplifier (30).

9. A device according to claim 8 characterised in that the control device (28) comprises a comparator.

10. A device according to claim 7 characterised in that the actual value generator (24) comprises a rectifier.

11. A device according to one of claims 6 to 10 characterised in that the reference value generator (25) comprises the series connection of a series resistor (R') and the source-drain path of a field effect transistor (32).

12. A device according to one of claims 6 to 11 characterised in that the reference value/actual value differencing means (26; 27) comprises at least a differential amplifier (26).

13. A device according to claim 12 characterised in that the differential amplifier (26) is connected as an inverting amplifier and connected on the output side thereof in cascade relationship is a further inverting amplifier (27).

14. A device according to claim 12 or claim 13 characterised in that the differential amplifier (26) has two actual value inputs ($E_1$, $E_4$) of which the first input ($E_1$) is connected to the output and the other input ($E_4$) is connected to the input of the actual value generator (24).

15. A device according to claim 3 or claim 4 characterised in that all current and sensor connection contacts (1 to 5) of the Hall element (22) are elongate in the same direction, that there is a ring (8) which is provided with the ring connection (R) and which at least laterally surrounds the active zone (7) of the Hall element (22) and is of opposite material conductivity type from the active zone (7) of the Hall element (22) and is subdivided into sub-rings (I, II, III) by intermediate web portions (13, 14) which extend approximately perpendicularly to the longitudinal direction of the current and sensor connection contacts (1 to 5), all the sub-rings being of approximately the same width perpendicularly to the longitudinal direction of the current and sensor connection contacts (1 to 5) and all being arranged in superposed relationship in said longitudinal direction without mutual displacement, wherein each two adjacent sub-rings (I and II, II and III) have a common intermediate web portion (13 and 14 respectively) and that all current and sensor connection contacts (1 to 5) are sufficiently long to bridge over all layers which are surrounded by the sub-rings (I, II, III).

16. A device according to claim 1 or claim 2 characterised in that the electrically conductive gate layer (10) is formed by three gate layers (10a, 10b, 10c) which are arranged in parallel juxtaposed relationship and which are separated from each other, wherein the middle gate layer (10b) covers in an upward direction the part of the active zone (7) in which three middle connection contacts (1, 4, 5) of the Hall element are contained, that the other two gate layers (10a, 10c) each cover in an upward direction a respective part of the active zone (7) in which a respective further connection contact (2, 3) of the Hall element is contained, and that all three gate layers (10a, 10b, 10c) each have a respective gate connection (G, OL, OR).

17. A device according to claim 3 or claim 4 characterised in that the two outer connection contacts (2, 3) are annular and each laterally surround a respective contact region (2a and 3a respectively) of a gate connection (OL and OR respectively), wherein the contact regions (2a, 3a) of the gate connections (OL, OR) are heavily doped with impurity atoms and are of opposite material conductivity type (P) from the two outer connection contacts (2, 3).

18. Use of the device according to one of claims 1 to 17 in a wattmeter or in an electricity meter for measuring an electrical current or for forming a voltage/current product.

**Claims for AT, BE, CH, LI and SE**

1. A device comprising a Hall element which can be integrated in an integrated circuit and which has two sensor connection contacts and at least two current connection contacts which are arranged at the surface in the Hall element characterised in that arranged at least between the active zone (7) of the

EP 0 204 135 B1

Hall element (22) and the surface of the Hall element (22) is a barrier layer (11 or 12; 7) which covers the active zone (7) of the Hall element (22) in an upward direction.

2. A device according to claim 1 characterised in that the output ($S_1$) of the Hall element (22) is connected by way of a regulating circuit (24; 25; 26; 27) to a control input (M) of the Hall element (22), which controls the thickness of the barrier layer (11 or 12; 7).

3. A device according to claim 2 characterised in that the regulating circuit (24; 25; 26; 27) comprises at least an actual value generator (24), a reference value generator (25) and a reference value/actual value differencing means (26; 27).

4. A device according to claim 3 characterised in that the absolute value generator (24) is a means for forming an absolute value.

5. A device according to claim 4 characterised in that the actual value generator (24) comprises at least a change-over switch (29) controlled by a control device (28), and an inverting amplifier (30).

6. A device according to claim 5 characterised in that the control device (28) comprises a comparator.

7. A device according to claim 4 characterised in that the actual value generator (24) comprises a rectifier.

8. A device according to one of claims 3 to 7 characterised in that the reference value generator (25) comprises the series connection of a series resistor (R′) and the source-drain path of a field effect transistor (32).

9. A device according to one of claims 3 to 8 characterised in that the reference value/actual value differencing means (26; 27) comprises at least a differential amplifier (26).

10. A device according to claim 9 characterised in that the differential amplifier (26) is connected as an inverting amplifier and connected on the output side thereof in cascade relationship is a further inverting amplifier (27).

11. A device according to claim 9 or claim 10 characterised in that the differential amplifier (26) has two actual value inputs ($E_1$, $E_4$) of which the first input ($E_1$) is connected to the output and the other input ($E_4$) is connected to the input of the actual value generator (24).

12. A device according to one of claims 1 to 11 characterised in that the barrier layer (11) is formed by a depletion zone which is produced by electrostatic influence by means of an electrical voltage which is applied by way of a gate connection (G) to an electrically conductive gate layer (10), that the gate layer (10) is arranged on the surface of the Hall element (22), separated by an oxide layer (9), in such a way that the gate layer (10) and therewith also the depletion zone covers the active zone (7) of the Hall element (22) in an upward direction and that the ring connection (R) of a ring (8) which at least laterally surrounds the active zone (7) of the Hall element (22) and which is of opposite material conductivity type from the active zone (7) of the Hall element (22) forms a control input (M) of the Hall element (22).

13. A device according to one of claims 1 to 11 characterised in that the barrier layer (12; 7) is formed by the interface between the active zone (7) of the Hall element (22) and a layer (12) which is arranged at the surface in the Hall element (22) and which is of opposite material conductivity type (P) from the active zone (7) of the Hall element (22) and which covers said active zone (7) in an upward direction, and that the layer (12) is in electrical contact with a ring connection (R) which forms a control input (M) of the Hall element (22).

14. A device according to claim 3 characterised in that all current and sensor connection contacts (1 to 5) of the Hall element (22) are elongate in the same direction, that there is a ring (8) which is provided with the ring connection (R) and which at least laterally surrounds the active zone (7) of the Hall element (22) and is of opposite material conductivity type from the active zone (7) of the Hall element (22) and is subdivided into sub-rings (I, II, III) by intermediate web portions (13, 14) which extend approximately perpendicularly to the longitudinal direction of the current and sensor connection contacts (1 to 5), all the sub-rings being of approximately the same width perpendicularly to the longitudinal direction of the current and sensor connection contacts (1 to 5) and all being arranged in superposed relationship in said longitudinal direction without mutual displacement, wherein each two adjacent sub-rings (I and II, II and III) have a respective common intermediate web portion (13 and 14 respectively) and that all current and sensor connection contacts (1 to 5) are sufficiently long to bridge over all layers which are surrounded by the sub-rings (I, II and III).

15. A device according to claim 12 characterised in that the electrically conductive gate layer (10) is formed by three layers (10a, 10b, 10c) which are arranged in parallel juxtaposed relationship and which are separated from each other, wherein the middle gate layer (10b) covers in an upward direction the part of the active zone (7) in which three middle connection contacts (1, 4, 5) of the Hall element are contained, that the other two gate layers (10a, 10c) each cover in an upward direction a respective part of the active zone (7) in which a respective further connection contact (2, 3) of the Hall element is contained, and that all three gate layers (10a, 10b, 10c) each have a respective gate connection (G, OL, OR).

16. A device according to claim 13 characterised in that the two outer connection contacts (2, 3) are annular and each laterally surround a respective contact region (2a and 3a respectively) of a gate connection (OL and OR respectively), wherein the contact regions (2a, 3a) of the gate connections (OL, OR) are heavily doped with impurity atoms and are of opposite material conductivity type (P) from the two outer connection contacts (2, 3).

17. Use of the device according to one of claims 1 to 16 in a wattmeter or in an electricity meter for

14

measuring an electrical current or for forming a voltage/current product.

**Revendications pour DE, FR, GB, IT, NL**

1. Dispositif comportant un élément de Hall (22) intégrable dans un circuit intégré, qui possède deux contacts de connexion de capteurs (4, 5) et au moins deux contacts de connexion de courants (1, 2 ou 1, 2, 3), qui sont disposés sur la surface supérieure dans l'élément de Hall (22), caractérisé en ce qu'au moins entre la zone actice (7) de l'élément de Hall (22) et la surface supérieure de l'élément de Hall (22) est disposée une couche diélectrique (11) qui recouvre le dessus de la zone active (7) de l'élément de Hall (22), en ce que la couche diélectrique (11) est constituée par une zone d'appauvrissement qui est créée par influence électrostatique à l'aide d'une tension électrique qui au moyen d'une connexion de grille (G) est adjacente à une couche (10) de grille électriquement conductrice, en ce que la couche (10) de grille est disposée séparée par une couche (9) d'oxyde sur la surface supérieure de l'élément de Hall (22) d'une manière telle que la couche (10) de grille et de cette façon la zone d'appauvrissement recouvrent le dessus de la zone active (7) de l'élément de Hall (22).

2. Dispositif selon la revendication 1, caractérisé en ce que la connexion annulaire (R) d'un anneau (8), qui entoure au moins latéralement la zone active (7) de l'élément de Hall (22) et qui est du type de conductibilité de matériau opposé à celui de la zone active (7) de l'élément de Hall (22) constitue une entrée de commande (M) de l'élément de Hall (22).

3. Dispositif comportant un élément de Hall (22) intégrable dans un circuit intégré, qui possède deux contacts de connexion de capteurs (4, 5) et au moins deux contacts de connexion de courants (1, 2 ou 1, 2, 3), qui sont disposés sur la surface supérieure dans l'élément de Hall, caractérisé en ce qu'au moins entre la zone active (7) de l'élément de Hall (22) et la surface supérieure de l'élément de Hall (22) est disposée une couche diélectrique (12; 7) qui recouvre le dessus de la zone active (7) de l'élément de Hall (22), en ce que la couche diélectrique (12; 7) est constituée par la couche limite entre la zone active (7) de l'élément de Hall (22) et une couche (12) disposée sur la surface supérieure de l'élément de Hall (22), qui est du type (P) de conductibilité de matériau opposé à celui de la zone active (7) de l'élément de Hall (22) et qui recouvre le dessus de cette zone active (7), et en ce que la couche (12) possède un contact électrique avec une connexion annulaire (R), qui constitue une entrée de commande (M) de l'élément de Hall (22).

4. Dispositif comportant un élément de Hall (22) intégrable dans un circuit intégré, qui possède deux contacts de connexion de capteurs (4, 5) et au moins deux contacts de connexion de courants (1, 2, 3), qui sont disposés sur la surface supérieure dans l'élément de Hall, caractérisé en ce qu'au moins entre la zone active (7) de l'élément de Hall (22) et la surface supérieure de l'élément de Hall (22) est disposée une couche diélectrique (12, 7) qui recouvre le dessus de la zone active (7) de l'élément de Hall (22), et en ce que l'élément de Hall (22) est un élément de Hall vertical.

5. Dispositif selon l'une des revendications 1 à 4, caractérisé en ce que la sortie ($S_1$) de l'élément de Hall (22) est reliée par un circuit de régulation (24; 25; 26; 27) avec une entrée de commande (M) de l'élément de Hall (22) qui commande l'épaisseur de la couche diélectrique (11 ou 12; 7).

6. Dispositif selon la revendication 5, caractérisé en ce que le circuit de régulation (24; 25; 26; 27) se compose au moins d'un circuit de traitement (24) de valeur effective, d'un indicateur (25) de valeur de consigne et d'un soustracteur (26; 27) valeur de consigne/valeur effective.

7. Dispositif selon la revendication 6, caractérisé en ce que le circuit de traitement (24) de valeur effective travaille en valeur absolue.

8. Dispositif selon la revendication 7, caractérisé en ce que le circuit de traitemet (24) de valeur effective se compose au moins d'un commutateur (29) commandé par un dispositif (28) de commande et d'un amplificateur (30) à inversion.

9. Dispositif selon la revendication 8, caractérisé en ce que le dispositif (28) de commande se compose d'un comparateur.

10. Dispositif selon la revendication 7, caractérisé en ce que le circuit de traitement (24) de valeur effective se compose d'un redresseur.

11. Dispositif selon l'une des revendications 6 à 10, caractérisé en ce que l'indicateur (25) de valeur de consigne est constitué d'un montage en série d'une prérésistance (R') et de la partie "source-drain" d'un transistor (32) à effet de champ.

12. Dispositif selon l'une des revendications 6 à 11, caractérisé en ce que le soustracteur (26; 27) valeur de consigne/valeur effective se compose au moins d'un amplificateur différentiel (26).

13. Dispositif selon la revendication 12, caractérisé en ce que l'amplificateur différentiel (26) est connecté en tant qu'amplificateur à inversion et en ce que lui est relié en cascade un autre amplificateur (27) à inversion en aval de lui.

14. Dispositif selon la revendication 12 ou 13, caractérisé en ce que l'amplificateur différentiel (26) comprend deux entrées de valeurs effectives ($E_1$, $E_4$) dont la première ($E_1$) est reliée à la sortie et la deuxième ($E_4$) est reliée à l'entrée du circuit de traitement (24) de valeur effective.

15. Dispositif selon la revendication 3 ou 4, caractérisé en ce que tous les contacts (1 à 5) de connexion de courants et de capteurs de l'élément de Hall (22) sont longitudinaux dans la même direction, en ce qu'il existe un anneau (8) comportant la connexion annulaire (R) qui entoure au moins latéralement la zone active (7) de l'élément de Hall (22), qui est du type de conductibilité de matériau opposé à celui de la zone active (7) de l'élément de Hall (22), et qui, par des entretoises (13, 14) de tracé presque perpendiculaire à la direction longitudinale des contacts de connexion de courant et de capteurs (1 à 5), est divisé en sous-anneaux (I, II, III) qui tous possèdent, perpendiculairement à la direction longitudinale des contacts (1 à 5) de connexion de courants et de capteurs, une largeur presque égale et qui dans cette direction longitudinale sont tous disposés les uns audessus des autres sans glissement réciproque, deux sous-anneaux (I et II ou II et III) voisins possédant respectivement une entretoise commune (13 ou 14), et en ce que tous les contacts de connexion de courants et de capteurs (1 à 5) sont suffisamment longs pour enjamber toutes les couches qui sont entourées par les sous-anneaux (I, II, III).

16. Dispositif selon la revendication 1 ou 2, caractérisé en ce que la couche de grille (10) électriquement conductrice est constituée de trois couches conductrices (10a, 10b, 10c) disposées l'une près de l'autre et séparées l'une de l'autre, la couche de grille médiane (10b) recouvrant le dessus de la partie de la zone active (7) dans laquelle sont contenus trois contacts intermédiaires (1, 4, 5) de connexion de l'élément de Hall, en ce que les deux autres couches de grille (10a, 10c) recouvrent respectivement chacune le dessus d'une partie de la zone active (7), dans laquelle est respectivement contenu un autre contact de connexion (2, 3) de l'élément de Hall, et en ce que les trois couches de grille (10a, 10b, 10c) possèdent toutes respectivement une connexion de grille (G, OL, OR).

17. Dispositif selon la revendication 3 ou 4, caractérisé en ce que les deux contacts de connexion extérieurs (2, 3) sont annulaires et entourent respectivement latéralement une région de contact (2a ou 3a) d'une commande de grille (OL ou OR), les régions de contact (2a, 3a) des commandes de grille (OL, OR) étant fortement dopées en atomes étrangers et étant du type (P) de conductibilité de matériau opposé aux deux autres contacts (2, 3) de connexion extérieurs.

18. Emploi du dispositif selon l'une des revendications 1 à 17 dans un wattmètre ou dans un compteur électrique destiné à la mesure d'un courant électrique ou au calcul d'un produit tension/courant.

## Revendications pour AT, BE, CH, LI, SE

1. Dispositif comportant un élément de Hall intégrable dans un circuit intégré, qui possède deux contacts de connexion de capteurs et au moins deux contacts de connexion de courants, qui sont disposés sur la surface supérieure de l'élément de Hall, caractérisé en ce qu'au moins entre la zone active (7) de l'élément de Hall (22) et la surface supérieure de l'élément de Hall (22) est disposée une couche diélectrique (11 ou 12; 7) qui recouvre le dessus de la zone active (7) de l'élément de Hall (22).

2. Dispositif selon la revendication 1, caractérisé en ce que la sortie ($S_1$) de l'élément de Hall (22) est reliée par un circuit de régulation (24; 25; 26; 27) avec une entrée de commande (M) de l'élément de Hall (22) qui commande l'épaisseur de la couche diélectrique (11 ou 12; 7).

3. Dispositif selon la revendication 2, caractérisé en ce que le circuit de régulation (24; 25; 26; 27) se compose au moins d'un circuit de traitement (24) de valeur effective, d'un indicateur (25) de valeur de consigne et d'un soustracteur (26; 27) valeur de consigne/valeur effective.

4. Dispositif selon la revendication 3, caractérisé en ce que le circuit de traitement (24) de valeur effective travaille en valeur absolue.

5. Dispositif selon la revendication 4, caractérisé en ce que le circuit de traitement (24) de valeur effective se compose au moins d'un commutateur (29) commandé par un dispositif (28) de commande et d'un amplificateur (30) à inversion.

6. Dispositif selon la revendication 5, caractérisé en ce que le dispositif (28) de commande se compose d'un comparateur.

7. Dispositif selon la revendication 4, caractérisé en ce que le circuit de traitement (24) de valeur effective se compose d'un redresseur.

8. Dispositif selon l'une des revendications 3 à 7, caractérisé en ce que l'indicateur (25) de valeur de consigne est constitué d'un montage en série d'une prérésistance (R') et de la partie "source-drain" d'un transistor (32) à effet de champ.

9. Dispositif selon l'une des revendications 3 à 8, caractérisé en ce que le soustracteur (26; 27) valeur de consigne/valeur effective se compose au moins d'un amplificateur différentiel (26).

10. Dispositif selon la revendication 9, caractérisé en ce que l'amplificateur différentiel (26) est connecté en tant qu'amplificateur à inversion et en ce que lui est relié en cascade un autre amplificateur (27) à inversion monté en aval de lui.

11. Dispositif selon la revendication 9 ou 10, caractérisé en ce que l'amplificateur différentiel (26) comprend deux entrées de valeurs effectives ($E_1$, $E_4$) dont la première ($E_1$) est reliée à la sortie et la deuxième ($E_4$) est reliée à l'entrée du circuit de traitement (24) de valeur effective.

12. Dispositif selon l'une des revendications 1 à 11, caractérisé en ce que la couche diélectrique 11 est constituée par une zone d'appauvrissement qui est créée par influence électrostatique à l'aide d'une tension électrique qui au travers d'une connexion (G) de grille est adjacente à une couche (10) de grille électriquement conductrice, en ce que la couche (10) de grille est disposée séparée par une couche (9) d'oxyde sur la surface supérieure de l'élément de Hall (22) d'une manière telle que la couche (10) de grille et de cette façon la zone d'appauvrissement recouvrent le dessus de la zone active (7) de l'élément de hall (22), et en ce que la connexion annulaire (R) d'un anneau (8) qui entoure au moins latéralement la zone active (7) de l'élément de Hall (22) et qui est du type de conductibilité de matériau opposé à celui de la zone active de l'élément de Hall (22), constitue une entrée de commande (M) de l'élément de Hall (22).

13. Dispositif selon l'une des revendications 1 à 11, caractérisé en ce que la couche diélectrique (12; 7) est constituée par la couche limite entre la zone active (7) de l'élément de Hall (22) et une couche (12) disposée sur la surface supérieure de l'élément de Hall (22), qui est du type (P) de conductibilité de matériau opposé à celui de la zone active (7) de l'élément de Hall (22) et qui recouvre le dessus de cette zone active (7), et en ce que la couche (12) possède un contact électrique avec une connexion annulaire (R), qui constitue une entrée de commande (M) de l'élément de Hall (22).

14. Dispositif selon la revendication 13, caractérisé en ce que tous les contacts (1 à 5) de connexion de courants et de capteurs de l'élément de Hall (22) sont situés longitudinalement dans la même direction, en ce qu'il existe un anneau (8) comportant la connexion annulaire (R) qui entoure au moins latéralement la zone active (7) de l'élément de Hall (22), qui est du type de conductibilité de matériau opposé à celui de la zone active (7) de l'élément de Hall (22), et qui, au moyen d'entretoises (13, 14) de tracé presque perpendiculaire à la direction longitudinale des contacts (1 à 5) de connexion de courants et de capteurs, est divisé en sous-anneaux (I, II, III) qui tous possèdent, perpendiculairement à la direction longitudinale des contacts (1 à 5) de connexion de courants et de capteurs une largeur presque égale et qui sont tous disposés les uns au-dessus des autres dans cette direction longitudinale sans glissement réciproque, deux sous-anneaux (I et II ou II et III) voisins possédant respectivement une entretoise commune (13 ou 14), et en ce que tous les contacts (1 à 5) de connexion de courants et de capteurs sont suffisamment longs pour enjamber toutes les couches qui sont entourées par les sous-anneaux (I, II, III).

15. Dispositif selon la revendication 12, caractérisé en ce que la couche de grille (10) électriquement conductrice est constituée de trois couches conductrices (10a, 10b, 10c) disposées l'une près de l'autre et séparées l'une de l'autre, la couche de grille médiane (10b) recouvrant le dessus de la partie de la zone active (7) dans laquelle sont contenus trois contacts intermédiaires (1, 4, 5) de l'élément de Hall (22), en ce que les deux autres couches de grille (10a, 10c) recouvrent respectivement chacune le dessus d'une partie de la zone active (7), dans laquelle est respectivement contenu un autre contact de connexion (2, 3) de l'élément de Hall (22), et en ce que les trois couches de grille (10a, 10b, 10c) possèdent toutes respectivement une connexion de grille (G, OL, Or).

16. Dispositif selon la revendication 13, caractérisé en ce que les deux contacts de connexion extérieurs (2, 3) sont annulaires et entourent respectivement latéralement une région de contact (2a ou 3a) d'une commande de grille (OL ou OR), les régions de contact (2a, 3a) des commandes de grille (OL, OR) étant fortement dopées en atomes étrangers et étant du type (P) de conductibilité de matériau opposé aux deux autres contacts de connexion extérieurs.

17. Utilisation du dispositif selon l'une des revendications 1 à 16 dans un wattmètre ou dans un compteur électrique destiné à la mesure d'un courant électrique ou au calcul d'un produit tension-courant.

17

# Fig. 1

# Fig. 2

# Fig. 3

# Fig. 4

# Fig. 5

# Fig. 6

N

P

| 2 | C'2 | 4 | 1 | 5 | 3 |
|---|---|---|---|---|---|
| N⁺ | S₁ | N⁺ | C₁ | N⁺ | C"2 |

S₁

P

C₁

S₂

N⁺ · · N⁺ · N⁺ · N⁺ · N⁺

R

SUB
N⁺
17

12

7

P

8

6

# Fig. 7

C'2    S₁    C₁    S₂    C"2    R    SUB

i/2    i    i/2

P    P  N⁺  P  N⁺  P  N⁺  P  N⁺  P  N⁺  P  P    N⁺

N    12  2  12  4  12  1  12  5  12  3  12    P    N    17

8    N    7    8

N⁺    16

P    15

N

6

# Fig. 8

# Fig. 9

# Fig. 10

# Fig. 11

# Fig. 12

# Fig. 13

# Fig. 14

# Fig. 15

Fig. 16

Fig. 17

Fig. 18

Fig. 19

Fig. 20

# Fig.21

# Fig. 22

# Fig. 23

# Fig. 24

# Fig.25